(19) **Europäisches Patentamt / European Patent Office / Office européen des brevets**

(11) **EP 3 496 167 B1**

(12) **EUROPEAN PATENT SPECIFICATION**

(45) Date of publication and mention
of the grant of the patent:
**06.04.2022 Bulletin 2022/14**

(21) Application number: **17836891.6**

(22) Date of filing: **28.07.2017**

(51) International Patent Classification (IPC):
*H01L 39/22* (2006.01)    *G01R 33/02* (2006.01)
*G01R 33/035* (2006.01)    *G01T 1/29* (2006.01)
*H01J 37/24* (2006.01)    *G01R 19/00* (2006.01)

(52) Cooperative Patent Classification (CPC):
**G01R 33/02; G01R 19/0061; G01R 33/035;**
**G01T 1/29; H01J 37/243; H01L 39/22**

(86) International application number:
**PCT/JP2017/027580**

(87) International publication number:
**WO 2018/025786 (08.02.2018 Gazette 2018/06)**

(54) **CHARGED PARTICLE BEAM CURRENT MEASUREMENT APPARATUS**

STROMMESSVORRICHTUNG FÜR GELADENEN TEILCHENSTRAHL

APPAREIL DE MESURE DE COURANT DE FAISCEAU DE PARTICULES CHARGÉES

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority:  **03.08.2016   JP 2016153257**

(43) Date of publication of application:
**12.06.2019   Bulletin 2019/24**

(73) Proprietor: **Riken**
**Wako-shi, Saitama 351-0198 (JP)**

(72) Inventors:
• **WATANABE, Tamaki**
**Wako-shi**
**Saitama 351-0198 (JP)**
• **FUKUNISHI, Nobushisa**
**Wako-shi**
**Saitama 351-0198 (JP)**

(74) Representative: **Huebner, Stefan Rolf et al**
**Postfach 101317**
**80087 München (DE)**

(56) References cited:
WO-A1-2005/076039    JP-A- 2003 021 670
JP-A- 2014 143 243    US-A- 4 324 255
US-A1- 2006 237 660    US-A1- 2007 229 057

• TANABE T ET AL: "A cryogenic current-measuring device with nanoampere resolution at the storage ring TARN II", NUCLEAR INSTRUMENTS & METHODS IN PHYSICS RESEARCH. SECTION A, ELSEVIER BV * NORTH-HOLLAND, NL, vol. 427, no. 3, 21 May 1999 (1999-05-21), pages 455-464, XP004166540, ISSN: 0168-9002, DOI: 10.1016/S0168-9002(99)00058-3
• PAVEL RIPKA: "TOPICAL REVIEW;Electric current sensors: a review;Topical Review", MEASUREMENT SCIENCE AND TECHNOLOGY, IOP, BRISTOL, GB, vol. 21, no. 11, 24 September 2010 (2010-09-24), page 112001, XP020199870, ISSN: 0957-0233, DOI: 10.1088/0957-0233/21/11/112001

EP 3 496 167 B1

## Description

Technical Field

The present invention relates to a device for measuring a current of a charged particle beam. More specifically, the present invention relates to a charged particle beam current measurement apparatus capable of detecting intensity of a charged particle beam with high sensitivity.

Background Art

Methods for measuring flow of charge by the charged particle beam (hereinafter referred to as "beam current") have been developed for the purpose of measuring while a charged particle beam generated is being output by a particle accelerator or the like. A typical ammeter or current measurement apparatus for that purpose is one with a superconducting material formed in an annular or tubular shape for allowing a beam of charged particles to pass through the center of the ring or tube. The measurement principle of such a method is that the magnetic field generated under the Ampere's law due to the beam current generates an induced current in the ring or tube, and the secondary magnetic flux produced by the induced current is measured by a magnetic sensor. Since the secondary magnetic flux at that time is extremely weak, a sensor (hereinafter referred to as "SQUID sensor") based on a superconducting quantum interference device (SQUID; Superconducting Quantum Interference Device), which is a highly sensitive magnetic sensor, is adopted. Since the induced current is a superconducting current flowing through the superconductor, the effect of the induced current that is further generated from the magnetic field, which has been generated by the beam, has the same effect of an eddy current (shielding current) in the Meissner effect of the superconductor, in which the superconductor exhibits perfect diamagnetism.

The inventors have developed a highly accurate current measurement apparatus that does not require liquid helium in RIBF (Radioisotope Beam Factory) at RIKEN (for example, Non-Patent Document 1). The RIBF beam current measurement apparatus uses a superconducting material (hereinafter referred to as "high-$T_c$ superconductor") that has a superconducting critical temperature Tc of relatively high temperature that can be reached by a freezer without requiring liquid helium. However, since high temperature superconductors are generally made of oxides or the like and are materials close to ceramics, it is difficult to perform machining after it is formed into a high temperature superconductor material. Then, in the beam current measurement apparatus manufactured by the present inventor, different high temperature superconductor materials are adopted for realizing highly accurate measurement based on their functions: one is a function of creating an induced current and generating the measured magnetic flux, and another is a function of magnetic shield (Patent Document 1, Non-Patent Documents 1 and 4, and Non-Patent Document 2). Furthermore, we have developed a beam current measurement apparatus with a compact device configuration by adopting separate members that can be assembled by contact them with each other, where the separate members performs functions of generating magnetic field to be detected and works as a magnetic shield (Patent Document 2).

Citation List

Patent Documents

    Patent Document 1: JP 2004-356573 A
    Patent Document 2: JP 2014-143243 A US 2006/237660

A1 discloses a nondestructive beam current measuring apparatus that includes a SQUID magnetic field sensor which has a superconducting ring structure.

A similar beam current measuring apparatus is known from JP 2003021670 A. In this apparatus, a magnetic field generated by the beam current passes a gap of a superconducting magnetic shield without being attenuated, and is collected by a detection coil formed by winding a superconducting wire on a core, to induces a magnetic flux in a SQUID.

Non-Patent Documents

    Non-Patent Document 1: Tamaki Watanabe, Masayuki Kase, and Takeshi Katayama, "SQUID to choudendoujikisi-rudo wo motiita koukando biimu denryuu monitaa no kaihatsu" [in Japanese] ("Development of a Highly Sensitive Beam Current Monitor with a SQUID and Supercondution Magnetic Shield"), TEION KOGAKU Vol.38 (2003) No.9 pp.509-521.

Non-Patent Document 2: Watanabe T., Fukunishi N., Sasaki Y., Kase M., Goto A., and Kamigaito O., "Development of Beam Current Monitor with High-Tc SQUID at RIBF" Proceedings of BIW10, Santa Fe, New Mexico, US, WEIANB02, (2010)

Non-Patent Document 3: M. Kuchnir et al., "SQUID based beam current meter," IEEE Trans. on Magnetics 21, 2, 997-999, (1985), DOI:10.1109/TMAG.1985.1063601

Non-Patent Document 4: Michael I. Faley, "Epitaxial Oxide Heterostructures for Ultimate High-Tc Quantum Interferometers," Chapt. 7 in "Applications of High-Tc Superconductivity," (Adir Moyses Luiz ed.), InTech, (2011), ISBN 978-953-307-308-8, DOI: 10.5772/2522, Chapter 7 URL:http://cdn.intechopen.com/pdfs-wm/16189.pdf [Last Retrieved: July 14, 2016]

Non-Patent Document 5: Shuetsu Haseyama, Shuji Yoshizawa, and Norifumi Murakami, "Supuree tohuhou ni yoru gin kibanjyou Bi2212 choudendou atsumaku rinkai denryuu (Jc) no koujyou" [in Japanese] ("Improvement of Jc of Thick Bi--2212 Film Spray-painted on an Ag Substrate"), J. Japan Inst. Metals, Vol. 66, No. 7 (2002), pp. 723-727

Tanabe T et al in: "A cryogenic current-measuring device with nanoampere resolution at the storage ring TARN 11", Nuclear instruments and Methods in Physics Research, Section A (Elsevier), vol. 427, no. 3, 21 May 1999 (1999-05-21), pages 455 to 464 discloses a current measurement apparatus according to the preamble of claim 1.

Summary of Disclosure

Technical Problem

However, there is a continuing need for adopting a device configuration that is comparable to or smaller than that of the above-described conventional beam current measurement apparatus, and for measuring a weaker beam current. The present invention at least solves either of these problems.

Solution to Problem

The inventors have analyzed the factors determining the measurement limit of weak current in the conventional beam current measurement apparatus in detail. Then, we have developed a configuration of a beam current measurement apparatus that can achieve high sensitivity without increasing the size of the device, and thus completed the present invention.

Specifically, there is provided: a current measurement apparatus for a charged particle beam with the features of claim 1, comprising: a magnetic core of a high permeability material encircling a space region and substantially forming a ring around an axis passing through the space region, an induction ring disposed substantially coaxially with the magnetic core, the induction ring forming a ring around the axis and occupying at least a part of the space region, wherein the induction ring is provided with a superconductor on, out of a surface or a surface layer thereof, a part or all of an axis-side surface region being opposite to the axis and a core-side surface region being opposite the magnetic core, the superconductor being configured to transmit therethrough a superconducting current along a path in a poloidal direction; and a SQUID sensor having a magnetic flux detection part magnetically coupled to a magnetic flux passing inside of the magnetic core in a toroidal direction.

The beam current measurement apparatus of the above aspect comprises a magnetic core of a high magnetic permeability material and an induction ring having a superconductor disposed on at least a part of the surface or the surface layer. By arranging the induction ring substantially coaxially with the magnetic core, the magnetic field generated around it in accordance with the beam current induces a current in the superconductor of the induction ring. The current is a superconducting current having intensity that amounts to complete diamagnetism of Meissner effect due to superconductivity. Although this current is an induced eddy current, it is possible to generate a secondary magnetic flux if properly guided. For this purpose the annular shape is adopted for the induction ring. Highly sensitive detection will be achieved by adopting a configuration in which the magnetic flux is detected by a SQUID sensor directly while preventing leak of the magnetic field as much as possible and eliminating the influence of the external magnetic field. As will be described later in the embodiment, the beam current measurement apparatus having such a configuration can achieve highly sensitive detection without significantly increasing the overall size.

The beam current measurement apparatus according to the invention further comprises a shield ring disposed substantially coaxially with the magnetic core and forming a ring around the axis, wherein the induction ring and the shield ring form an annular housing space for accommodating the magnetic core and the housing space is substantially surrounded by superconductor.

The shield ring accommodates a magnetic core into the annular housing space together with the induction ring and helps a role of a magnetic shield for magnetically isolating the magnetic core in the housing space from the external of the induction ring and the shield ring. Substantially every entry pathway that may allow the magnetic noise affecting the magnetic core and the SQUID sensor to invade into are blocked, except a minimum path used for maintaining the function of the beam current measurement apparatus. The minimum entry pathway used to maintain the function of this beam current measurement apparatus is not only a path for taking out the signal line of the magnetic sensor to the outside but also ones for insulation between the induction ring and the shield ring. In this preferable structure, the magnetic noise from the external is effectively suppressed by the Meissner effect of the induction ring and the function of the shield ring, and high-precision current detection operation can be realized. As a result, it will be possible to minimize the adverse effect of the detection sensitivity due to external magnetic noise.

Advantageous Effects of Disclosure

In the beam current measurement apparatus according to any one of the embodiments of the present invention, it is possible to accurately measure a weak current of a weak charged particle beam while keeping the size of the device relatively compact.

Brief Description of Drawings

FIG. 1 is a schematic diagram showing a configuration of an LTc-SQUID ammeter as an example of conventional beam current measurement apparatuses.

FIG. 2 is a schematic diagram showing a configuration of an HTc-SQUID ammeter as an example of conventional beam current measurement apparatus.

FIG. 3 is a schematic circuit diagram of a circuit system including a SQUID sensor in a conventional LTc-SQUID ammeter.

Fig. 4 illustrates a typical configuration example of a beam current measurement apparatus in an embodiment of the present invention, where a partially broken exploded perspective view (FIG. 4A) and a sectional view (FIG. 4B) are provided for its essential part.

FIG. 5 is a schematic diagram showing a beam current measurement apparatus model that is electromagnetically equivalent to the magnetic core of the beam current measurement apparatus shown in FIG. 4 in the embodiment of the present invention.

FIG. 6 is a partially broken perspective view of a beam current measurement apparatus model including an induction ring, a shield ring, and a magnetic core having a rectangular frame shape adopted for numerical calculation by a finite element method in an embodiment of the present invention.

FIG. 7 is a schematic cross-sectional view depicting a configuration for shielding an ambient magnetic field to a beam current measurement apparatus by a soft magnetic shield in an embodiment of the present invention.

FIG. 8 is a perspective view schematically illustrating an arrangement of a magnetic field generating device and an ambient magnetic sensor adapted to the beam current measurement apparatus in an embodiment of the present invention.

FIG. 9 includes cross-sectional views of the relationship between the magnetic cores and the SQUID sensor in the beam current measurement apparatus according to the embodiment of the present invention, illustrating a configuration with the magnetic gap (FIG. 9A), one without the magnetic gap (FIG. 9B), one having an antenna core (FIG. 9C), and a configuration in which funnel portions are provided in the magnetic core using the antenna core (FIG. 9D).

Fig. 10 includes scanning electron microscope images of surfaces of test pieces observed after baking and annealing of Bi2212 test pieces for the beam current measurement apparatus in the embodiment of the present invention, where FIGS. 10A to 10D sequentially show the combinations of (surrounding gas, annealing rate) combination for (air, -4 °C/h), (air, -12 °C/h), (oxygen, -4 °C/h), and (oxygen, -12 °C/h).

Fig. 11 is a chart of X-ray diffraction obtained by forming a Bi2212 test piece for a beam current measurement apparatus according to an embodiment of the present invention for an annealing gas at an annealing rate of -4 °C/h.

Fig. 12 is a chart of X-ray diffraction obtained by forming a Bi2212 test piece for a beam current measurement apparatus according to an embodiment of the present invention for an oxygen gas at an annealing rate of - 12 °C/h.

Fig. 13 is a graph showing the magnetic susceptibility measured by raising and lowering the temperature in order to measure the superconducting critical temperature in the Bi2212 test pieces for the beam current measurement apparatus according to the embodiment of the present invention.

FIG. 14 is a graph of a hysteresis characteristic of a magnetic susceptibility for measuring a superconducting critical current in a Bi2212 test pieces for a beam current measurement apparatus according to an embodiment of the present invention.

FIG. 15 is an explanatory diagram for illustrating a setup for the operation verification in an example of the beam current measurement apparatus according to an embodiment of the present invention.

FIG. 16 is a photograph of display on an analog oscilloscope for an output waveform from the SQUID controller in an example of the beam current measurement apparatus of the present invention.

FIG. 17 is a photograph of display on an FFT analyzer in the frequency space obtained by the FFT processing of the output waveform of the SQUID controller in an example of the beam current measurement apparatus of the present invention.

Description of Embodiments

Hereinafter, embodiments of a beam current measurement apparatus according to the present invention will be described with reference to the drawings. In the description, common parts or elements have common reference numerals unless otherwise noted. Also, in the figure, each element of each embodiment is not necessarily drawn to scale.

1. Analysis of Behavior of Beam Current Detecting Device

The description begins with the operation of the conventional beam current detecting apparatus, as the idea of operational principle in the embodiments of the present invention was obtained with the help of detailed knowledge through analysis.

1-1. Conventional Example 1 (FNAL LTc-SQUID Ammeter)

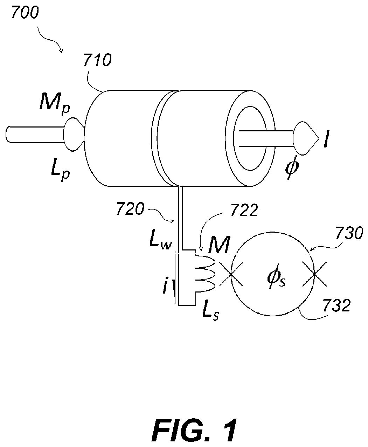

FIG. 1 shows a configuration of an LTc-SQUID ammeter 700 created by FNAL (Fermi National Accelerator Research Institute, USA) (Non-Patent Document 3), which is an example of a conventional beam current measurement apparatus. As shown in FIG. 1, the superconducting pickup loop 710 is connected to the superconducting input circuit 720. A coil for SQUID (SQUID input coil) 722 having self-inductance $L_s$ is further connected to the superconducting input circuit 720. As the beam passes through the superconducting pickup loop 710, the induced current flows so as to cancel the charge flow of the charged particle beam. For example, if the charged particles are positively charged, the shielding current i flows inside and outside the superconducting pickup loop 710 toward a direction opposite to the beam inside, or toward the same direction outside as the charged particle beam. Since the superconducting pickup loop 710 is operated below the superconducting transition temperature, the shielding current i is a superconducting current and is responsible for perfect diamagnetism for the Meissner effect. The shielding current i also flows to the superconducting input circuit 720 to generate magnetic flux in the SQUID input coil 722. The magnetic flux is transmitted to the SQUID sensor 730. FIG. 1 also shows the symbols indicating the amounts involved in this operation. These meanings and typical values are shown in Table 1.

[Table 1]

| Symbol | Amount Represented | Typ. |
|---|---|---|
| I | Beam Current | |
| i | Current flowing thru S Conducting Input Circuit | |
| $M_p$ | Mutual Inductance of Charged Particle Beam and Pickup Loop (Approx. Eq. to Lp) | 14 nH |
| $L_p$ | Self-Inductance of Pickup Loop | 14 nH |
| $L_w$ | Self-Inductance betw. Pickup Loop - Twisted Wire of SQUID Input Coil Connection | 17 nH |
| $L_s$ | Self-Inductance of SQUID Input Coil | 2000 nH |
| M | Mutual Inductance Of SQUID Loop and SQUID Input Coil Connection | 20 nH |

The magnetic flux $\varphi$ generated according to Ampere's law around the beam current I in the LTc-SQUID ammeter 700 shown in FIG. 1 is prevented from entering into the superconducting pick-up loop 710 due to the Meissner effect, whose amount is expressed in the following formula.

[Math 1]

$$\phi = M_p I = L_p I \qquad (1)$$

The current i flowing through the SQUID input coil 722 according to this magnetic flux $\varphi$ is:

[Math 2]

$$i = \frac{\phi}{L_p + L_w + L_s} \quad . \tag{2}$$

By using the mutual inductance M between the loop (SQUID loop) 732 of the SQUID sensor 730 and the SQUID input coil 722, the magnetic flux $\varphi_s$ in the SQUID loop 732 is expressed by the following formula.
[Math 3]

$$\phi_s = Mi = M \frac{L_p}{L_p + L_w + L_s} I \tag{3}$$

The beam current I and the current i flowing through the SQUID input coil 722 are expressed as follows.
[Math 4]

$$i = \frac{L_p}{L_p + L_w + L_s} I \tag{4}$$

By substituting the above values into this, a relationship of i = I/145 is obtained. Calculating the magnetic flux $\varphi_s$ generated in the SQUID loop 732 for a beam current of 1 μA from Formula (3), $\varphi_s = 6.67 \times 10^{-2} \varphi_0$ using the flux quantum $\varphi_0$ as a unit.

1-2. Conventional Example 2 (HTc-SQUID ammeter of RIKEN)

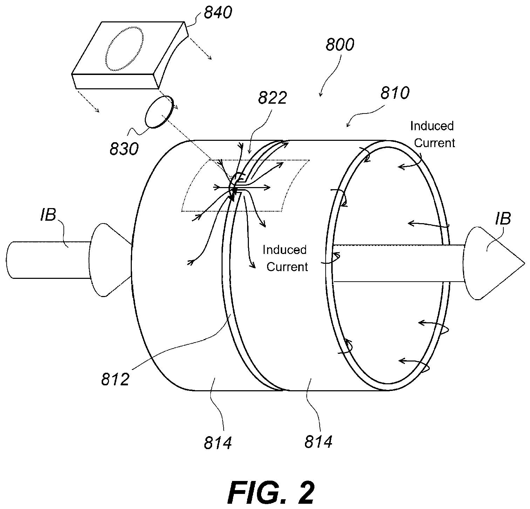

FIG. 2 is a schematic diagram showing the structure of an HTc-SQUID ammeter 800, which is another example of a conventional beam current measurement apparatus operating as a prototype at RIKEN (Patent Document 2). The HTc-SQUID ammeter 800 includes an HTS current sensor tube 810, a magnetic sensor 830, and a magnetic shielding member 840. The HTS current sensor tube 810 includes a tubular member 812 and a high temperature superconductor film 814 formed using the tubular member 812 as a substrate. The cylindrical member 812 is configured to allow passage of the charged particle beam IB in the direction of the cylinder axis inside. The high temperature superconductor film 814 is a film of a high temperature superconductor that exhibits a superconducting critical temperature Tc higher than the liquid helium temperature and is formed on the inner surface, the outer surface, and the end surfaces of the tubular member 812. Magnetic sensor 830 is positioned proximate to the bridge 822. Formulas (1) to (4) can be adopted for operation analysis of the HTc-SQUID ammeter 800, as the bridge portion 822 operates as the input coil 722 (FIG. 1) of FIG. 1. Since the sensitivity of the HTc-SQUID ammeter 800 has already been measured, the purpose of analysis here is to investigate the operating mechanism that determines the performance and its actual numerical range.
First, the coupling coefficient $\alpha$ is defined as follows.
[Math 5]

$$\alpha = \frac{L_p}{L_p + L_w + L_s} \tag{5}$$

As is apparent from the Formula (4), the coupling coefficient $\alpha$ is the ratio of the current i flowing through the input coil to the beam current I. Representing Formula (3) by this coupling coefficient $\alpha$ gives the following.
[Math 6]

$$\phi_s = M\alpha I \tag{6}$$

On the other hand, from Ampere's law, the magnetic field $B_{calc}$ that the current i creates at a location with a distance r (mm) from the center is:
[Math 7]

$$B_{calc} = \frac{\mu_0 i}{2\pi r} \quad .\qquad (7)$$

In the case of the HTc-SQUID ammeter 800 shown in FIG. 2, the conducting portion (corresponding to the SQUID loop 732 in FIG. 1) of the SQUID gradiometer used as the SQUID sensor 830 is positioned 6 mm away from the input coil (bridge portion 822). To reflect this, substituting the value of 6 mm into Equation (7), the calculated magnetic field $B_{calc}$ at the beam current of 1 $\mu$A is 33.3 pT. Here, the actual SQUID gradiometer has a sensitivity of 0.9 nT/V in actual measurement, and the sensitivity of the prototype HTc-SQUID ammeter is actually measured to be 10 mV/$\mu$A. From these, it can be said that the actual value of the magnetic flux density directly measured by the SQUID gradiometer in this prototype is 9 pT for the beam current I of 1 $\mu$A. Based on this measured value and the calculated magnetic field $B_{calc}$, the coupling coefficient $\alpha$ is calculated to be 0.270. Since the relationship between the magnetic flux of the SQUID gradiometer and the magnetic field has been measured beforehand, substituting the magnetic flux of $2.17 \times 10^{-2}$ $\varphi_0$ in the case of 1 $\mu$A into the Equation (6), The mutual inductance M between the SQUID loop and the superconducting current sensor of the bridge circuit is calculated to be to be 0.166 nH.

Since the HTS current sensor cylinder 810 corresponding to the superconducting pickup loop 710 (FIG. 1) has the outer diameter $R_0$, the inner diameter $R_i$, and the height h, the self-inductance $L_p$ of the HTS current sensor cylinder 810 is expressed based on the analysis of a general toroidal core as the following Formula (8).
[Math 8]

$$L_p = \frac{N^2}{2\pi} \mu_0 \mu_r h \ln\left(\frac{R_o}{R_i}\right) \qquad (8)$$

In the case of prototype HTc-SQUID ammeter 800, the self-inductance $L_p$ of the HTS current sensor cylinder 810 is calculated to be 7.04 nH, for $r_2$ = 49.5 mm, $r_1$ = 43.0 mm, h = 250 mm, and the relative magnetic permeability $\mu_r$ = 1. By using this value and setting N = 1 in Equation (5), the self-inductance $L_s$ of the superconducting current sensor bridge circuit is calculated to be 19.0 nH.

1-3. Conventional Example 3 (LTc-SQUID ammeter in TARN-II)

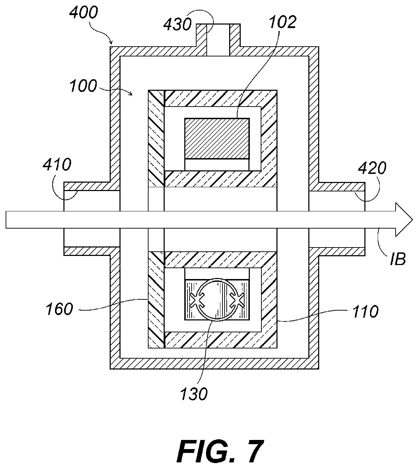

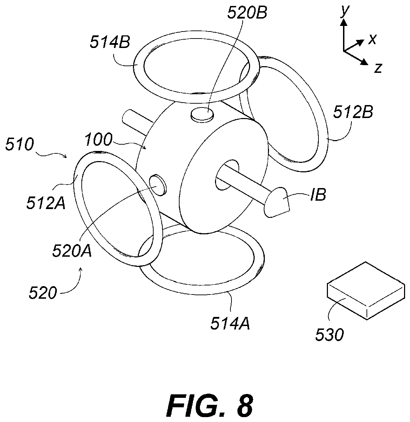

Based on a SQUID ammeter adopted in the past at TARN-II (High Energy Accelerator Research Organization; Non-Patent Document 1, Fig.7 and Fig.8) as an example, the magnetic flux generated by the beam current is calculated, and resolution of the beam current measurement will be described. This resolution should be compared with the noise level of TARN-II's LTc-SQUID ammeter, and the measured LTc-SQUID ammeter's sensitivity is 5 mV/nA.

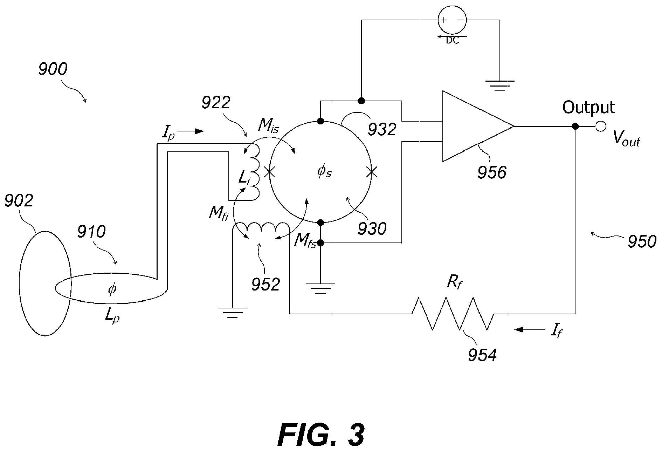

FIG. 3 shows a schematic circuit diagram of a circuit system including the SQUID sensor of the LTc-SQUID ammeter 900 of TARN-II. The LTc-SQUID ammeter 900 has a feedback path 950 for FLL (Flux Lock Loop) operation, which includes a feedback coil 952, a feedback resistor 954, and a buffer amplifier 956. Here, the pickup coil 910 is wound around the magnetic core 902, and a current generated by the passage of the charged particle beam causes a magnetic flux in the pickup coil 910 (that is, inside the magnetic core 902). The pickup coil 910 and the input coil 922 including wiring between them are made of niobium superconducting wire. With such a configuration, the magnetic flux $\varphi$ generated in the magnetic core 902 causes a magnetic flux in the SQUID sensor 930 via the superconducting current $I_p$ in the superconducting wire. The specifications of the magnetic core 902 are as shown in Table 2.

[Table 2]

| Items | Details |
| --- | --- |
| Magnetic Core | 6025F, Manfactured by Vitrovac, Germany |
| Magnetic Permeability | 25,000 |
| Outer Diameter Ro | 400 mm |
| Inner Diameter Ri | 322 mm |
| Height h | 25 mm |

(continued)

| Items | Details |
|---|---|
| The Number of Turns n | 1 |

By substituting these values into the above Formula (8), the inductance of the magnetic core 902, that is, the self inductance of the pickup coil 910 is found to be 27 $\mu$H.

The meanings of the parameters in FIG. 3 and typical values thereof are as shown in the following Table 3.

[Table 3]

| Symbol | Amount Represented | Typ. |
|---|---|---|
| $L_p$ | Self-Inductance of Pickup Coil 910 | 27 $\mu$H |
| $L_i$ | Inductance of Input Coil 922 | 17 nH |
| Mis | Mutual Inductance betw. Input Coil 922 and SQUID Loop 932 | 5 nH |
| $M_{fi}$ | Mutual Inductance betw. Feedback Coil 952 and Input Coil 922 | 6 nH |
| $M_{fs}$ | Mutual Inductance betw. Feedback Coil 952 and Squid Loop 932 | 2 pH |
| $R_f$ | Feedback Resistor 954 | 4.7 k |

Since the magnetic flux $\varphi$ is generated in the pickup coil 910, the following relationship holds regarding the shielding current $I_p$ induced in a loop including the pickup coil 910 and the input coil 922.

[Math 9]

$$\phi = (L_p + L_i)I_p \qquad (9)$$

However, since $L_p \gg L_i$, it can be approximated as follows.

[Math 10]

$$\phi \sim L_p I_p \qquad (10)$$

Since the magnetic flux $\varphi_s$ is transmitted to the SQUID sensor 930 by the current $I_p$, the following relationship holds.

[Math 11]

$$\phi_s = M_{is}I_p = M_{is}\,\phi/L_p \qquad (11)$$

When the magnetic flux is locked by the feedback measurement, the current If flows through the feedback coil 952 so that the magnetic flux in the SQUID loop 932 is cancelled to zero. Therefore, assuming the output voltage $V_{out}$ is the output voltage of the SQUID sensor 930, the magnetic flux $\varphi_s$ can be expressed by the following equation.

[Math 12]

$$\phi_s = M_{fs}(eff)I_f = M_{fs}(eff)\,V_{out}/R_f \qquad (12)$$

In this case, it is expressed as Mfs (eff) as it represents an effective mutual inductance between the feedback coil 952 and the SQUID loop 932. Its value is determined by the magnetic flux transmission from the feedback coil 952, including directly transmitted to the SQUID loop 932 (i.e., Mfs) and transmitted via the input coil 922. That is, Mfs (eff) is expressed as follows.

[Math 13]

$$M_{fs}(eff) = M_{fs} - M_{fi}M_{is}/(L_p + L_i)$$
$$\sim M_{fs} - M_{fi}M_{is}/L_i \qquad (13)$$

In summarizing the above process, the relationship between the signal magnetic flux φ and the output voltage $V_{out}$ is derived as follows.
[Math 14]

$$V_{out} = (M_{is}R_f\phi)/(L_pM_{fs} - M_{fi}M_{is}) \qquad (14)$$

Next, the signal magnetic flux φ is obtained by using detailed numerical values according to these and compared with the actual output. Assuming that the self-inductance $L_p$ of the pickup coil 910 is 27 μH, the signal magnetic flux φ to be generated in the pickup coil 910 for the beam current of 1 nA is $2.7 \times 10^{-14}$ weber, and the calculated output voltage $V_{out}$ is 26 mV. On the other hand, the actual sensitivity of the LTc-SQUID ammeter 900 is 5 mV when 1 nA as described above. From these, it can be said that the actual sensitivity corresponds to about 1/5 of the calculated output.
From Equation (11), the magnetic flux $\varphi_s$ on the SQUID sensor 930 is $5 \times 10^{-18}$ weber. Here, the flux-equivalent noise of the LTc-SQUID ammeter 900 is 10 $\mu T\varphi_0$ / Hz $^{1/2}$ = 2.07 E-20 weber or less. Therefore, when the bandwidth is 1 Hz, the magnetic flux generated by the beam current of 1 nA is approximately 250 times the flux-equivalent noise of the LTc-SQUID ammeter 900. The signal bandwidth equivalent to this noise level is 15 Hz.

2. Improvement (Embodiment)

Based on the above detailed knowledge obtained by analyzing the behavior of various beam current measurement apparatus, the inventors have noted that there are important parameters for increasing the sensitivity of the SQUID ammeter. Each of the above findings is independent of the superconducting transition temperature of the superconductor, and it summarizes electromagnetic coupling conditions between the pickup coil, the input coil, and the SQUID sensor. In addition, since it is the signal-to-noise ratio (SN ratio) that determines the resolution of the beam ammeter, all we can do for increasing the resolution in a situation where the noise component cannot be suppressed should be to increase the signal component. The signal component is the magnetic flux $\varphi_s$ transmitted onto the SQUID sensor in Equation (12). We pay attention to increasing the self-inductance $L_p$ of the pickup coil in order to effectively increase this magnetic flux $\varphi_s$.
That is, when the self-inductance $L_p$ increases, even if the accompanying inductance exists, the shielding surface current accompanying the beam current may coincide with the beam current due to the Meissner effect when the accompanying inductance is negligible. As is apparent from Equation (11), if the self-inductance $L_p$ of the pickup coil is significant, so is true for the magnetic flux φ gathered, and the magnetic flux $\varphi_s$ transmitted onto the SQUID also becomes significant. Furthermore, at the LTc-SQUID ammeter 900 (FIG. 3), the magnetic flux obtained by the pickup coil 910 is temporarily converted into an electric current, the magnetic flux is generated by the input coil 922 of the SQUID sensor, and the magnetic flux is transmitted to the SQUID sensor 930. If there is leakage of the magnetic flux in this mechanism, there is a possibility that the transmitted magnetic flux will decrease. Therefore, in order to improve the HTc-SQUID ammeter, the inventors have adopted a structure (referred to as "direct coupling") which makes it difficult for leakage of magnetic flux to occur in principle and realizes a high coupling coefficient.

2-1. Direct Coupling

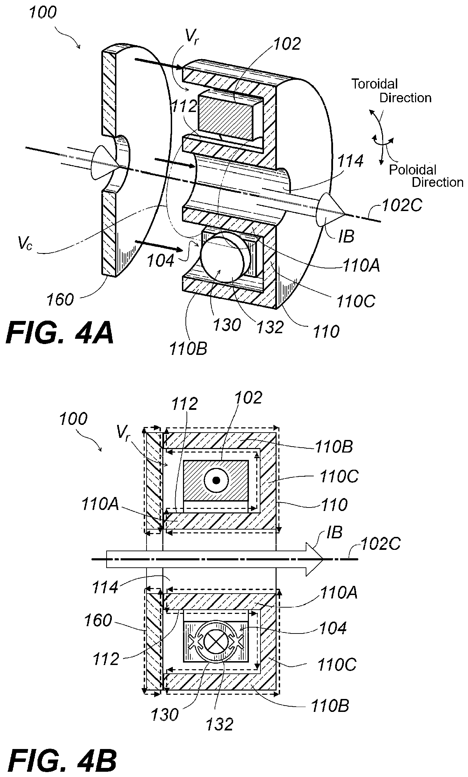

FIG. 4 includes a partially broken exploded perspective view (FIG. 4A) and a cross sectional view thereof (FIG. 4B) showing a main part in a typical configuration example of the beam current measurement apparatus 100 of the present embodiment. The beam current measurement apparatus 100 of the present embodiment is provided with a magnetic core 102 and an induction ring 110 which are made of a high magnetic permeability material and substantially form rings. Looking at relative arrangement between them, the induction ring 110 is arranged generally coaxially with respect to the magnetic core 102, thus they are typically disposed coaxially with each other as shown in the drawings. The typical orientation of the charged particle beam IB in such coaxial arrangement is such that its direction is set to the same as the common rotational symmetry axis, i.e., axis 102C, of the induction ring 110 and the magnetic core 102. The relative arrangement of the induction ring 110 and the magnetic core 102, as well as the relative arrangement of the directions of the charged particle beam IB with respect to these can be appropriately adjusted as necessary. The induction ring 110 and the magnetic core 102 shown in the shape of a torus are typical examples, and thus they may be made into, for example, a rectangular annular shape or other sort of annular shapes when implementing the present embodiment. Here, the magnetic core 102 and the induction ring 110 made of the high magnetic permeability material can have any shape, and are not limited to a specific shape such as a circular ring shown as a typical example in FIG. 4. However, for the purpose of explanation, in the following description, the magnetic core 102 is assumed to have generally a toroid shape (circular ring), and the induction ring 110 also is assumed to have a symmetric ring with rotational symmetry with an axis of rotational symmetry existing on the axis 102C of the magnetic core 102, or arranged coaxially.

The induction ring 110 in the beam current measurement apparatus 100 of the configuration example includes an inner cylinder part 110A and an outer cylinder part 110B which are coaxial with each other. The space sandwiched between the inner cylinder part 110A and the outer cylinder part 110B is closed by the bottom portion 110C in one of the extending directions of the axis 102C. Therefore, as shown in FIG. 4, the induction ring 110 in the beam current measurement apparatus 100 has a C-shaped cross section, while generally forming a ring. In the induction ring 110, an annular space (housing space $V_r$) is defined in which three sides are enclosed and one side is opened due to the C-shaped cross section.

On the other hand, the magnetic core 102 itself generally forms an annulus around a certain axis 102C and encircles the space region $V_c$ through which the axis 102C passes. At least a part of the space region $V_c$ is occupied by a part of the induction ring 110. In the configuration example of FIG. 4, the inner tubular portion 110A of the induction ring 110 occupies a part of the space region $V_c$. The magnetic core 102 is made of a high permeability material. Therefore, when a current flows in the surrounding space of the magnetic core 102 which is annular, a magnetic field generated around the current generates a magnetic flux toward the toroidal direction in the magnetic core 102.

The induction current of the induction ring 110 is a superconducting current having a component in the poloidal direction, and a magnetic flux is generated in the toroidal direction inside the magnetic core 102 which is arranged coaxially (FIG. 4B). Here, as shown in FIG. 4A, the toroidal direction is a direction rotating around the axis of rotational symmetry of a circular ring and the poloidal direction is the direction of the trajectory drawn by rotating motion around an axis of rotation laying along the toroidal direction at each position of the surface of the ring.

The surface of the induction ring 110 includes a core-side surface region 112 being opposite to the magnetic core and an axis-side surface region 114 being opposite to the axis 102C. A superconductor is disposed on a part of the surface of the induction ring 110 or the surface layer. Typically, the superconductor includes the surface or the surface layer of the induction ring 110 including the sides facing the magnetic core 102. Here, the surface or the surface layer means a layer having a certain thickness reaching the literal outmost surface, and in addition, it also means that formation of additional substance in the upper layer of the superconductor is allowed, when the added substance that does not affect the electromagnetic induction or the superconducting nature. Further, the surface or a part of the surface layer means that there may be a region where a superconductor is not disposed as long as a path for the superconducting current conduction is secured in the poloidal direction. The material of the substrate on which the superconductor of the induction ring 110 is formed is not particularly limited, and any material suitable for forming a superconductor can be adopted, for example. What can be selected for such a material includes, for example, a material which does not inhibit the crystal growth of the superconductor or a material which does not form an alloy with the superconductor. In the drawings of the present application, although the range of the superconductor is not specified in the cross section of the induction ring 110, entire part of the thickness of the induction ring 110 may be made of a superconductor. However, it is not necessary to form the induction ring 110 entirely by a superconductor. The thickness of the superconductor is preferably, for example, a thickness exceeding the penetration depth of the magnetic field.

The current that causes the magnetic core 102 to generate the magnetic flux is typically a shielding current superconducting through the induction ring 110 in the poloidal direction (FIG. 4B). In the present embodiment, the shielding current is superconducting current and is conducted in the poloidal direction, as the superconductor is disposed on part or all of the core-side surface region 112 and the axis-side surface region 114 as well as at least a part of this spatial region. In FIG. 4B, this superconducting current is indicated by chain lines.

Here described is the case when the charged particle beam IB travels along the axis 102C, which is the axis of rotational symmetry with respect to the magnetic core 102 and the induction ring 110. The magnetic field generated by the beam current induces shielding current in the poloidal direction on the induction ring 110 according to the Meissner effect under Ampere's law and the right-hand grip rule. The shield current in the poloidal direction generates a magnetic flux inside the magnetic core. In FIG. 4B, both the current and the charged particle beam IB are indicated by arrows according to the direction of flow of the electric charge. It is to be noted that, in the case when the charged particle beam IB is negatively charged particles, the charged particle beam IB and the beam current are opposite to each other, so that both the current and the magnetic flux are reversed. In addition, since the superconductor is formed on the surface or the surface layer of the induction ring 110, the magnetic flux of the magnetic core 102 hardly leaks from the housing space $V_r$, and deterioration of the coupling coefficient $\alpha$ caused by such leakage of the magnetic flux is prevented.

A shield ring 160, which also forms a ring, is disposed over the opening of the housing space $V_r$. The shield ring 160 is generally adapted to the shape of the induction ring 110 and typically has a disc shape with an opening. As shown in FIG. 4B, the shield ring 160 shown in the exploded perspective view of FIG. 4A completes the housing space $V_r$ for the magnetic core 102 together with the induction ring 110 by closing the opening of the induction ring 110 at the time of use. For the shield ring 160 in this embodiment, both of the following can be adopted: one is made of a high magnetic permeability material (high magnetic permeability shield ring), and the other is one with a superconducting material formed at least on the surface or the surface layer (superconducting shield ring) similarly to the induction ring 110. In the following description, a configuration example in the case of a superconducting shield ring will be described as a typical example of the shield ring 160 unless otherwise specified. In the configuration example, the shielding current in the direction to prevent the entry of the magnetic field by the charged particle beam IB flows also in the superconductor of the shield ring 160 in the poloidal direction for the shield ring that has become the superconducting current according to the Meissner effect (FIG. 4B).

When the shield ring 160 is adopted, a shielding current that have direct effect on the magnetic core 102 is, among the superconducting currents flowing in the induction ring 110 and the shield ring 160, its component that flows in a region facing the magnetic core 102. Therefore, as viewed from the magnetic core 102, the direction of the current indicated by the induced superconducting current is inverted between inside and outside of the induction ring 110. In FIG. 4B, if the electric charge of the charged particle beam IB is positive, magnetic flux is generated in such a way that a magnetic flux is generated in a direction protruding from a paper surface on a paper surface in the upper half above the charged particle beam IB, and a magnetic flux is generated in a direction toward the back side of the paper surface in the lower half below the charged particle beam IB. In FIG. 4B, the relationship between the paper surface and the direction of the magnetic flux is indicated by a mark for seeing the arrowhead from the tip and a mark for seeing the arrow blade from behind. When such a shield ring 160 is adopted, since the magnetic flux of the magnetic core 102 is confined in the housing space $V_r$ formed by the shield ring 160 and the induction ring 110, deterioration of the coupling coefficient $\alpha$ caused by the leakage of the magnetic flux is prevented. The magnetic flux induced in the direction of passing in the toroidal direction inside the magnetic core 102 corresponds to the magnetic field created in the housing space $V_r$ by the superconducting current flowing in the superconductors of the induction ring 110 and the shield ring 160.

When a superconducting current is conducted between the surface of the induction ring 110 and the surface of the shield ring 160, there should be a component of superconducting current that flows only through the outer surfaces of the induction ring 110 and the shield ring 160. Since such a component does not contribute to generation of a magnetic flux in the magnetic core 102, it also causes the magnetic flux to weaken as compared with the beam current value. For stable measurement operation, a member (not shown) for electrical insulation is provided for preventing the induction ring 110 and the shield ring 160 from contacting each other.

The SQUID sensor 130 is disposed on the magnetic core 102 so as to have a SQUID loop 132 serving as a magnetic flux detecting portion at a position magnetically coupled with a magnetic flux passing through the magnetic core 102. The fact that the magnetic core 102 is made of a high permeability material has the effect of increasing the self-inductance of the magnetic core 102 through a high magnetic flux density (Formula (2)). Furthermore, due to the high magnetic permeability of the magnetic core 102, it also has the function of concentrating the magnetic flux created by the induced current into the SQUID loop 132 of the SQUID sensor 130, that is, the magnetic flux detector.

The above description concerning the superconducting shield ring is also applicable substantially in the case where the shield ring 160 is a high permeability shield ring made of a high permeability material. In that case, if the high permeability material of the high permeability shield ring has a sufficient thickness, the housing space $V_r$ and the external ambient do not magnetically affect each other. This point is the same as in the case of the superconducting shield ring. A slight modification from the description of the superconducting shield ring is associated with the fact that no superconducting current flows through the shield ring 160. In the case of high magnetic permeability shield ring, magnetic flux generated in the magnetic core 102 in the case of the high magnetic permeability shield ring is limited to one that is generated by the superconducting current in the poloidal direction through the induction ring 110, as a superconducting current in the poloidal direction is not induced in the shield ring 160 as in FIG. 4B. Therefore, even if a high permeability shield ring is adopted, the beam current can be measured with no problem in principle.

For a direct coupling configuration for detecting the magnetic flux generated in the magnetic core 102, the present inventors believe that both configurations are promising, one is a configuration that forms a magnetic gap in the magnetic core 102 and the other is a configuration that does not form a magnetic gap. First, the configuration using the magnetic gap will be described, and then the one using no magnetic gap will be described.

2-2. Coupling with SQUID Sensor Using Magnetic Gap A typical magnetic core 102 in direct coupling using a magnetic gap is provided with a magnetic gap 104 in which the high magnetic permeability material is interrupted in the toroidal direction and has an annular shape as a whole. The SQUID sensor 130 is arranged so that the magnetic flux detecting portion is located in the magnetic gap 104. The SQUID sensor 130 is typically an HTc-SQUID sensor employing a high temperature superconductor. For example, the SQUID sensor 130 is disposed in the magnetic gap 104 so as to be sandwiched between the end faces of the magnetic core 102. By quantifying the magnetic flux at that position by the SQUID sensor 130, the beam current generated by the charged particle beam IB can be measured.

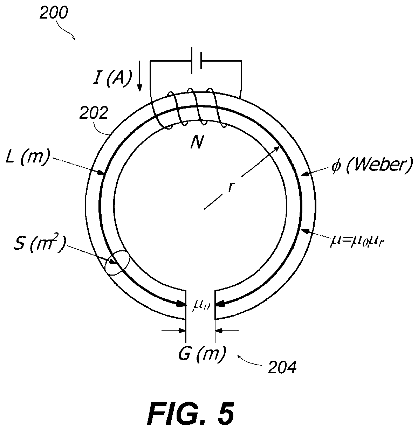

The measurement performance of the beam current measurement apparatus 100 in this configuration example can be estimated as follows. FIG. 5 is a schematic diagram showing a virtual core model 200 that is electromagnetically equivalent to the magnetic core 102 of the beam current measurement apparatus of the present embodiment shown in FIG. 4. A magnetic gap 204 (length G) is formed in the magnetic core 202. This magnetic gap 204 corresponds to the gap 104 (FIG. 4) where the SQUID sensor 130 is disposed. The parameters for analyzing the operation of the magnetic circuit of FIG. 5 are given as in Table 4.

[Table 4]

| Symbol | Amount Represented |
|---|---|
| I | E Current Flowing Thru Magnetic Core |
| N | The Number of Turns of Coil |
| $\phi$ | Magnetic Flux |
| $\mu_r$ | Specific Permeability of Magnetic Core |
| M | Magnetic Permeability Magnetic Core |
| S | Cross-Sectional Area of Magnetic Core |
| L | Magnetic Path Length of Magnetic Core $\sim 2\pi r$ |
| G | Air Gap Length |

Here, the magnetomotive force $F_m$ is expressed as follows.
[Math 15]

$$F_m = NI \tag{15}$$

Using the magnetic flux $\varphi$ and the magnetoresistance $R_m$, the following relationship holds.
[Math 16]

$$F_m = \varphi R_m \tag{16}$$

Furthermore, in the virtual core model 200 having this magnetic gap 204, the magnetic resistance $R_m$ for the entire magnetic circuit of the magnetic core 202 is represented by:
[Math 17]

$$R_m = \frac{L}{\mu S} + \frac{G}{\mu_0 S} \; . \tag{17}$$

The magnetic flux $\varphi$ is expressed as
[Math 18]

$$\varphi = \frac{NI}{\frac{L}{\mu S} + \frac{G}{\mu_0 S}} = \frac{NIS}{\frac{L}{\mu} + \frac{G}{\mu_0}} \tag{18}$$

by using Expressions (15) and (16). For example, when the magnetic core 202 is made of a high magnetic permeability material and the magnetic gap 204 is air or a non-magnetic material refrigerant, the condition $\mu \gg \mu_0$ is satisfied. In that case, equation (18) can be approximated as:
[Math 19]

$$\varphi = \frac{\mu_0 NIS}{G} \qquad . \qquad (19)$$

In order to evaluate such operation, the numerical value is estimated for a case when the beam current I is set to I = 1 nA. In the estimate, N = 1 because the charged particle beam is a single pass, and reflects detailed specifications (noted in Table 5) of an exemplary HTc-SQUID sensor actually fabricated.

[Table 5]

| Symbol | Amount Represented | Actual Values |
|---|---|---|
| S | Effective Area of Input Coil | 4.2 mm$^2$ |
| G | HTC-SQUID Sensor Height | 10 mm |
| $\phi_N$ | Mag Flux Equiv to Noise of HTC-SQUID Sensor | $4.1 \times 10^{-20}$ weber/Hz$^{1/2}$ (10 $\mu$T $\phi_0$/HZ$^{1/2}$) |

For carrying out the calculation, we assume that the cross-sectional area S and the air gap G of the magnetic core 202 are set to be equal to the effective area and height of the HTc-SQUID sensor, respectively. Substituting these values into Equation (19), the magnetic flux $\varphi_s$ on the HTc-SQUID sensor is $5.3 \times 10^c$ weber. That is, the magnetic flux produced by the 1 nA beam current for the bandwidth of 1 Hz is about 13 times the flux-equivalent noise of the HTc-SQUID sensor.

Note that the ratio calculated by the LTc-SQUID ammeter developed for TARN-II is about 250 times (Section 1-3 above). In order to realize the same value as this ratio even when adopting the beam current measurement apparatus according to the present embodiment, the shape may be adjusted based on Equation (19). For example, if the air gap is set to 1/10 of 1 mm and the effective area of the input coil to 8.4 mm$^2$ ,which is 2 times of the previous. Therefore, a configuration that improves the SN ratio by about 20 times is realistic in this embodiment.

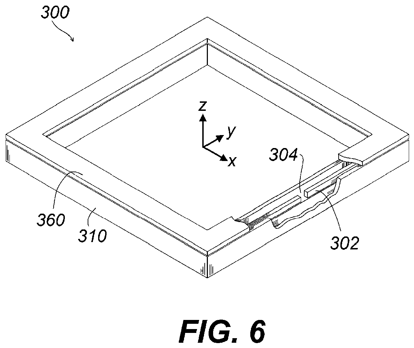

Furthermore, in order to confirm the estimation result by analytical approximate calculation leading to the Equation (19), numerical calculation by electromagnetic field simulation by the finite element method by OPERA 3D (manufactured by Cobham Technical Services, UK) was carried out. In the numerical calculation, for the sake of simplicity, what is adopted instead of the toroid shaped magnetic core 102 (FIG. 4) is a shape model having a magnetic core with a square rectangular frame shape and a relative permeability $\mu_r$ of $10^5$ is set, while the magnetic core is wrapped by conductors that serve as the induction ring 110 and the shield ring 160. FIG. 6 is a partially broken perspective view of a beam current measurement apparatus model 300 including an induction ring 310, a shield ring 360, and a magnetic core 302 having a rectangular frame shape adopted for numerical calculation by the finite element method. Unlike the induction ring 110 (FIG. 4), in the case of an object that is not in the shape of a toroid (for example, a rectangular frame shape in FIG. 6), the term "poloidal direction" refers to a direction laying on a plane that includes an axis passing through the ring and intersects the surface of the ring, where the direction traces an intersection line of the plane and the ring.

A similar rectangular frame shaped magnetic core 302 is accommodated in a housing space defined by a rectangular frame shaped induction ring 310 and a shield ring 360. In the rectangular frame shape of the magnetic core 302, the center of each side of the frame was made to coincide with the square side of 10 cm $\times$ 10 cm, and the cross section of the magnetic core on each side of the frame was 2 mm $\times$ 2 mm. This cross section is set to match the effective area of the SQUID loop serving as the magnetic flux detecting portion of the SQUID sensor (not shown). A magnetic gap 304 is formed in the magnetic core 302. The magnetic gap 304 was provided in the central portion in the longitudinal direction of only one side out of four sides forming a square frame with the length in the toroid direction being 1 cm. As a result of numerical calculation, under the condition of the beam current of 1 nA, the magnetic flux at the center of the magnetic gap 304 where the SQUID sensor should be placed was calculated as $8.6 \times 10^{-19}$ weber. This amounts to the same order as the result ($5.3 \times 10^{-19}$ weber) obtained based on the analytical approximation calculation leading to Equation (19). Thus, it was confirmed that both analytical calculation and numerical calculation yield similar results in performance prediction. In the case of using a magnetic gap, it was confirmed that the magnetoresistance increases as the gap is widened and the size is expanded. In order to increase the magnetic flux, it is important to make the magnetic gap into an appropriate structure.

2-3. Coupling With SQUID Sensor without Magnetic Gap Next, a configuration of direct coupling without using a magnetic gap will be described. The model adopted for the analytical calculation has the same structure as the virtual core model 200 shown in FIG. 5, except that the magnetic gap is formed into the annular shape without interruption. Assuming that the magnetic gap is G = 0 in Equation (18), the generated magnetic flux $\varphi$ can be expressed as follows.
[Math 20]

$$\varphi = \frac{\mu_r \mu_0 NIS}{L} \qquad\qquad (20)$$

Here, $\mu_r$ is the relative magnetic permeability. When the radius r of the magnetic core is 50 mm, the area S is 4 mm $^2$, the relative permeability $\mu_r$ is 10 $^5$, and the beam current I is 1 nA, the magnetic flux $\varphi$ is estimated to be 1.6 $\times$ 10 $^{-15}$ weber. This magnetic flux $\varphi$ is as much as 3000 times as large as the case with the magnetic gap of the HTc-SQUID ammeter (Section 2-3 above), and is about 300 times larger compared with the LTc-SQUID ammeter 900 (FIG. 3) used in TARN-II.

Further, a numerical calculation by the finite element method was carried out in a similar manner as in the case with a magnetic gap. In this calculation, OPERA 3D was used and the same structure was assumed for the magnetic core 302 of the beam current measurement apparatus model 300 shown in FIG. 6, except that the magnetic gap 304 were not provided. The relative magnetic permeability $\mu_r$ of the magnetic core was 10 $^5$, the shape of the core was a rectangular frame shape of a square of 10 cm square without a gap, and the cross section was 2 mm $\times$ 2 mm. As a result, the value of the magnetic flux $\varphi$ at the center of the core material in the magnetic core is calculated to be 5.0 $\times$ 10 $^{-15}$ weber, which was about 3 times of the value of the analytical calculation (1.6 $\times$ 10 $^{-15}$ weber). It was confirmed that, even in the case where the magnetic gap is not provided, similar results are obtained by both performance predictions for analytical and numerical calculation schemes.

2-4. Magnetic shield

2-4-1. Estimation of Magnetic Shield Performance

Furthermore, we have estimated how much the magnetic shield performance will be influenced by integrating the shield ring 160 and the induction ring 110 in comparison with the case when they are assumed to be separated from each other, or by using electrical insulation member as claimed and as described above. In general, shielding of external noise due to ambient magnetic field etc. is useful to increase the signal-to-noise ratio (SN ratio) that determines the measurement resolution of the beam current. The ambient magnetic field here may generally include the magnetic field generated by geomagnetism and one caused by other equipment installed nearby in the measurement area. If the complete diamagnetism due to the Meissner effect of the superconductor is realized it can be said that the external magnetic field should be shielded. In the actual configuration shown in FIG. 4, the induction ring 110 and the shield ring 160 are fabricated separately from each other with superconductors formed on the entire surface or surface layer. This structure is for accommodating the magnetic core of the present embodiment and is adopted also to generate a magnetic flux by an induced current with respect to the magnetic core. Furthermore, an insulating layer is sandwiched between the induction ring and the shield ring. On the other hand, due to these structures, there is a region where the superconductor is not continuous between the induction ring and the shield ring, therefore invasion of the ambient magnetic field may be a problem. For this reason, the performance of this shield was studied by reproducing the electromagnetic field on the computer by the finite element method.

Specifically, the extent of intrusion of the magnetic field into the housing space is estimated by numerical calculation while simulating the static magnetic field using TOSCA (manufactured by Dassault Systemes) for the beam current measuring apparatus model 300 shown in FIG. 6. In order to approximate the characteristics of the superconductor, the value of the relative magnetic permeability between the induction ring 310 and the shield ring 360 is assumed to 1.0 $\times$ 10 $^{-12}$ for the calculation. In other words, although perfect diamagnetism due to the Meissner effect has not been calculated correctly, a similar situation is assumed. Here, the shielding ratio S is defined as

$$S = \text{the magnetic field } S_{IN} \text{ inside the shield } /$$

the ambient magnetic field $S_{OUT}$ outside the shield.

Regions in which no superconductor exists between the guiding ring 310 and the shield ring 360 were considered in the model by providing a clearance having a thickness of 0.5 mm with a relative permeability of 1 between them. As a result, it was found that the shielding ratio S depends on the direction of the ambient magnetic field. Specifically, the shielding ratio for an ambient magnetic field oriented in the z direction on the coordinate axis shown in FIG. 6 was about 10 $^{-3}$ of the external at the entire circumferential position where the magnetic core 302 was arranged, which means there was almost no invasion from the external. On the other hand, when an external magnetic field is applied in the x direction or the y direction, the invasion of the magnetic field from gap between the induction ring 310 and the shield ring 360, or from the the break of the superconductor, was large, for example. The shielding rate S was almost 0.98 on the side extending in the x direction of the frame, and S was about 0.09 on the side extending in the y direction. As mentioned above, although the Meissner effect of the actual superconductor is not precisely considered in the calculation as described above, it was confirmed that the gap between the induction ring 310 and the shield ring 360 may have significant impact in terms of the magnetic shield of the ambient magnetic field.

2-4-2. Complement of Magnetic Shielding Performance From the above-mentioned circumstances, it can be said that we cannot expect completeness in magnetic shielding performance. Therefore, as a preferable configuration for supplementing a minor incompleteness of the magnetic shielding performance, it has been examined to adopt additional means to reduce the ambient magnetic field as much as possible at the position of the beam current measurement apparatus.

One of the concepts for the complementary improvement is providing a magnetic shield that encompasses the entire beam current measuring apparatus 100. Specifically, by disposing a magnetic shield (hereinafter referred to as "soft magnetic shield") made of permalloy which is a high magnetic permeability material (soft magnetic material) so as to be a single layer or multiple layers, it is possible to reduce the influence of the ambient magnetic field on the beam current measurement apparatus inside. FIG. 7 is a schematic cross-sectional view illustrating a configuration for shielding the ambient magnetic field to the beam current measuring apparatus 100 by the soft magnetic shield 400. In the soft magnetic shield 400, ports 410 and 420 for providing passage of the charged particle beam IB to and from the beam current measurement apparatus 100 are opened. Furthermore, in order to arrange a cold head (not shown) from a refrigerator for a low temperature environment for allowing a superconducting transition in the beam current measuring apparatus 100 as necessary, a chimney shaped cooling port 430 and a necessary space is provided. As described above, in the preferred soft magnetic shield 400, the magnetic shield plays a role of shielding cover while securing paths for proper functions of the device.

Another additional means is one for actively generating a magnetic field that cancels the ambient magnetic field. FIG. 8 is a perspective view schematically illustrating an arrangement including a magnetic field generating device 510 and an ambient magnetic sensor 520 that are adapted to a beam current measurement apparatus. A typical operation is to place the magnetic field generator 510 in the space surrounding the beam current measuring apparatus 100 for cancelling the ambient magnetic field. The ambient magnetic sensor 520 is used to measure the magnetic field generated by the magnetic field generator 510 and an ambient magnetic field due to other causes. The magnetic field generator 510 has two pairs of coils in total, or a pair of coils 512A and 512B and another pair of coils 514A and 514B, where the two pairs are oriented orthogonally with each other, so that a substantially uniform magnetic field can be generated in the space range where the beam current measurement apparatus is placed. This allows for intensity control of a magnetic field in an arbitrary direction in a plane orthogonal to the charged particle beam IB. In the magnetic field generating device 510 shown in FIG. 8, it is possible to apply a magnetic field in the x direction by the coils 512A and 512B and a magnetic field in the y direction by the coils 514A and 514B, when the direction of the charged particle beam IB is set to the z direction. Typically, a suitable controller 530 acts to operate the magnetic field generator 510 to cancel the ambient magnetic field in response to measured results from the ambient magnetic sensor 520, as exemplified by the directional sensors 520A and 520B or the like. In this way, the influence of the ambient magnetic field from the ambient on the measurement value of the beam current can be reduced. Its component laying on a plane perpendicular to the charged particle beam IB should be a magnetic field component that easily invades into the beam current measurement apparatus model 300 in FIG. 6.

2-5. Specific Materials and Structures

The magnetic core of this embodiment can be made of various high permeability materials. In addition to high magnetic permeability, it is preferable that the coercive force is sufficiently small and those characteristics can be maintained even at low temperature, in order to transmit magnetic flux due to a weak current with low noise and high linearity. For this purpose, it is possible to adopt such materials that may be adopted in conventional beam ammeters as amorphous iron-based alloys, amorphous cobalt-based alloys, crystalline alloys and nanocrystal materials, in particular, Fine Met (Hitachi Metals, Japan).

2-6. Magnetic Coupling between Magnetic Core and SQUID Sensor

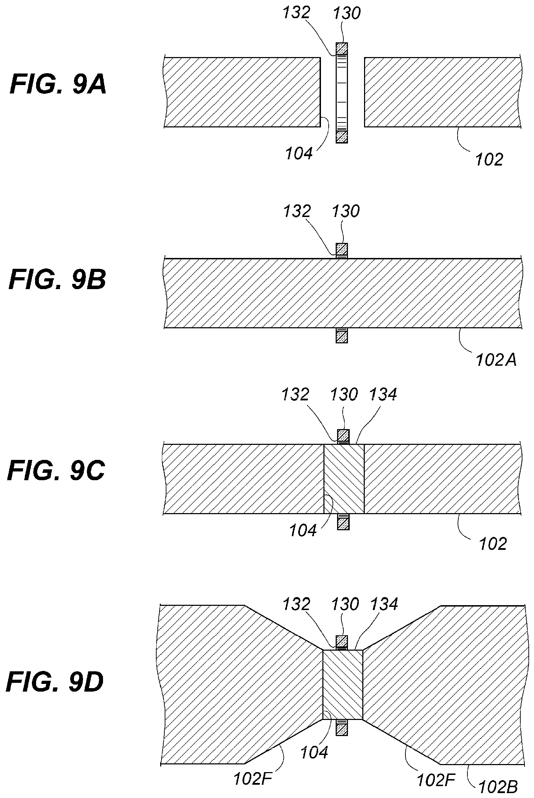

Furthermore, the magnetic core of the present embodiment can be implemented by, as described above, a configuration in which a magnetic gap is formed and a structure in which a magnetic gap is not formed. FIG. 9 includes cross-sectional views illustrating the relationship between the magnetic cores and the SQUID sensor. They are drawn on planes that cut themselves by planes that are parallel to the charged particle beam. Each figure shows a configuration in which a magnetic gap is provided on a magnetic core itself (FIG. 9A), a configuration in which a magnetic gap is not provided (FIG. 9B), a configuration having an antenna core (FIG. 9A), and a configuration in which funnel sections are provided in the magnetic core using the antenna core (FIG. 9D).

The configuration in which a magnetic gap portion is provided in the magnetic core shown in FIG. 9A is as shown in the beam current measurement apparatus 100 (FIG. 4), that is, the SQUID loop 132 of the SQUID sensor 130 is disposed in the magnetic gap 104 of the magnetic core 102 without any change. It can be relatively easily manufactured since it measures the magnetic flux leaked to the gap portion.

The configuration of the magnetic core 102A not provided with the magnetic gap shown in FIG. 9B has the magnetic core 102A passing through the SQUID loop 132 of the SQUID sensor 130. Such a configuration is advantageous if its magnetic aspect is the only factor to consider. On the other hand, some sort of improvements are necessary for fabrication. For example, it is possible to realize such a configuration by first making the SQUID sensor 130 and passing the magnetic core 102A through the SQUID loop 132. Increasing the cross-sectional area of the magnetic core 102A increases the magnetic flux that can be detected, so that the SN ratio can be further improved. For that purpose, the HTc-SQUID sensor 130 may have a large diameter and the magnetic core 102A passing therethrough also has an increased cross-section.

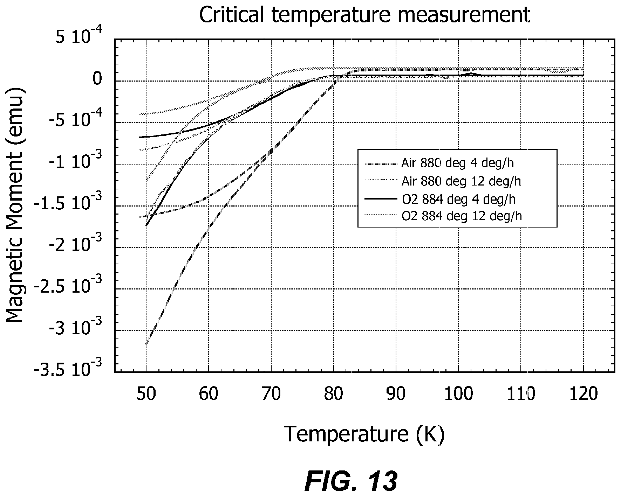

As one of the improvements in the above fabrication, it is possible to adopt a technique of passing the antenna core for the HTc-SQUID ammeter developed by the present inventor (Non-Patent Document 4: Chapter 7, page 169 and Fig.13 (b)). That is, as shown in FIG. 9C, it is useful to attach the antenna core 134 to the SQUID sensor 130. In this case, the magnetic core 102 provided with the magnetic gap 104 as shown in FIG. 4 may be adopted. The antenna core 134 is sandwiched while being brought into contact with both of the facing surfaces of the magnetic core 102 defining the magnetic gap 104, the magnetic flux can pass through the magnetic core 102 and the antenna core 134 without breaks. In this case, the magnetic operation is substantially the same as one with no magnetic gap, so that more magnetic flux is generated, magnetic resistance can be reduced, and self-inductance $L_p$ is increased. In addition, since the magnetic flux passes through the antenna core 134 without leakage and is detected by the SQUID sensor 130, the measurement sensitivity can be enhanced. The machining advantage in this configuration compared to passing the magnetic core through the SQUID loop 132 of the SQUID sensor 130 is its ease of assembly. That is, the following assembly scheme is relatively easy; the magnetic gap 104 is formed in the magnetic core 102, the antenna core 134 is passed through the SQUID loop 132 which is the magnetic flux detecting portion of the SQUID sensor 130, and these are magnetically integrated to form a structure having substantially no magnetic gap.

Furthermore, when the antenna core 134 is used, the sectional area of the magnetic core does not necessarily restrict the size of the SQUID sensor 130. This makes it possible to realize a more practical configuration. That is, as shown in FIG. 9D, when a small diameter SQUID sensor is adopted, it is possible to adopt the magnetic core 102B with the funnel portion 102F for providing a magnetic flux concentration portion. The cross-sectional area in the funnel portion 102F through which the magnetic flux passes is narrowed when it is traced toward the magnetic gap 104 in the toroidal direction. With such a structure, it is possible to magnetically couple the antenna core 134 to the magnetic gap 104 appropriately, and to concentrate the magnetic flux in the magnetic core 102B onto the antenna core 134 having a relatively small diameter. It is possible to avoid the difficulty that is expected when increasing the diameter of the SQUID sensor 130 while the thick magnetic core 102B that can increase the self-inductance is adopted.

It should be noted that it is not always necessary to combine the flux concentrating portion like the funnel portion 102F with only the SQUID sensor 130 to which the antenna core 134 is attached. It is also useful to detect the magnetic flux concentrated by the funnel portion 102F by the SQUID sensor 130 without placing either the antenna core or the magnetic core between the magnetic gaps 104 (not shown). Even when the magnetic gap 104 is present, if magnetic flux concentrated by the magnetic flux concentration portion such as the funnel portion 102F can be formed, the magnetic flux leaking from the magnetic gap 104 can be detected by the SQUID sensor 130, which increases the detection sensitivity.

2-7. Concrete Structure of the Guided Ring and Shield Ring

Regarding materials for producing the shield ring 160 by the induction ring 110 and the superconducting shield ring (FIG. 4), it is preferable to adopt silver for the material of the substrate or the substrate and bismuth oxide high temperature the superconductor Bi2212 (composition formula: $Bi_2Sr_2Ca_1Cu_2O_{8+\delta}$) or the like. In this case, a composition in which $\delta$ is an arbitrary value of 0 or more can be adopted. Bi2212 exhibits a relatively high superconducting transition temperature (Tc ~ 80 K), does not require cooling with liquid helium, and can form a superconductor layer with sufficient performance using silver as a substrate. Since silver does not form an alloy with Bi2212, silver does not adversely affect the superconducting property of Bi2212. Furthermore, a shape having a complexity of about C-shaped cross section such as the induction ring 110 and the shield ring 160 can be manufactured by a method using electron beam welding or the like. Even if the beam current measurement apparatus model 300 (FIG. 6) has a complicated shape, the same is true. In Bi2212 formed on the silver surface, a high superconducting transition temperature can be achieved by an appropriate film formation method such as a melting method with appropriate surrounding gas and temperature conditions. Therefore, the beam current measurement apparatus of the present embodiment gives high practicality. An example material that can be adopted for the substrate or substrate for the shield ring 160 by the induction ring 110 and the superconducting shield ring other than silver is MgO.

In the case where the shield ring 160 is made of a high permeability shield ring, a high permeability material such as permalloy can be adopted for the shield ring 160.

3. EXAMPLES

Examples of confirming the operation of the beam current measuring apparatus 100 of the present embodiment in the above will be specifically described below. Materials, amounts of use, proportions, processing contents, processing procedures, orientations, and specific arrangements of elements and members shown in the following examples can be appropriately changed as long as they do not depart from the gist of the present invention. Therefore, the scope of the present invention is not limited to the following specific examples. Further, the explanation of each of the above-mentioned drawings will continue to be referred to as it is in the description of the embodiment. In the embodiment, first, an experiment was conducted to search the forming condition of Bi2212 to be formed on the induction ring 110 and the shield ring 160. Second, by forming a superconductor on the induction ring 110 and fabricating a beam current measurement apparatus for operation verification having a configuration in which a high permeability shield ring is adopted for the shield ring 160 to be combined therewith, we succeeded in measuring the alternating current (simulated current) used in the current substitution, and the sensitivity could be determined.

3-1. Search for formation conditions of Bi2212

The fabrication conditions for forming the superconducting layer of Bi2212 on the actual induction ring 110 can be determined in such a way that good superconductivity is achieved, by adjusting various conditions such as surrounding gas, baking temperature, and annealing temperature from the baking temperature. For this example, optimization was carried out by adjusting the annealing rate in the air and the oxygen after preparing the raw materials based on the disclosure example of the superconducting layer of Bi2212 (Non-Patent Document 5). The evaluation metrics were surface SEM observation, crystallinity evaluation by X-ray diffraction, superconducting critical temperature, and superconducting critical current.

Specifically, $Bi_2O_3$, $SrCO_3$, CaO and CuO having a purity of 99.9% as a raw material were used, and further a small amount of Pb was added so that the composition ratio was Bi: Sr: Ca: Cu = 2: 2: 1: 2, for preparing a mixed powder. Calcination powder of Bi2212 was prepared by repeating burning and pulverizing to the mixed powder to make an average particle size of 3 $\mu$m. Thereafter, a superconductive paste was prepared by mixing the calcined powder of Bi2212 with an organic vehicle, and butyl acetate was added as a diluent so that it could be coated with a spray gun. This was applied to one side of a plurality of silver substrates (4 mm $\times$ 8 mm rectangle, 1.5 mm thickness) with a uniform thickness by a spray coating method. Then, in a forced air dryer operating at 150 °C for 30 minutes, a plurality of test pieces were prepared by spray coating and drying repeatedly. For the baking process for Bi2212, an electric furnace was used and each test piece was heated up at 60 °C/h while forcibly feeding oxygen through a ceramic tube inside the furnace in an oxygen, and then held for 10 minutes for baking. Then, immediately after the baking treatment, the temperature was gradually cooled from the temperature to 830 °C at a constant rate. In such a series of heat treatments, the applied material melts in the baking process, and a Bi2212 crystal having a perovskite structure is formed through an annealing process. The condition of the baking treatment for each surrounding gas has been surveyed beforehand, and it is set to 880 °C for the air and 884 °C for the oxygen (the temperatures are indicated values of the ambient thermometer in both cases). In the description of this example, what is explained is whether the air or the oxygen should be adopted, and whether the annealing rate should be -4 °C/h or - 12 °C/h. These conditions are merely examples and do not limit the conditions that can be adopted for the beam current measuring apparatus of the present embodiment.

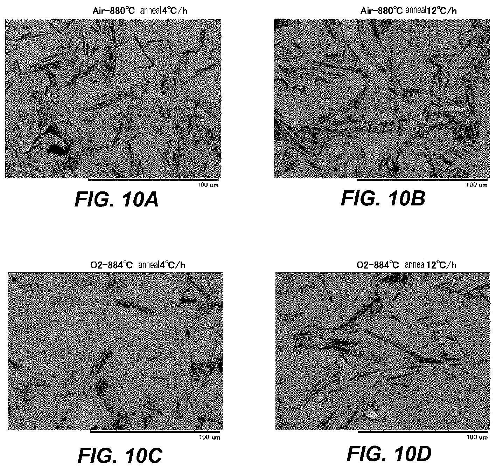

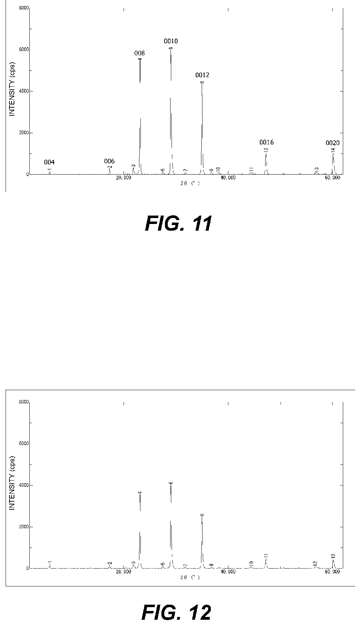

FIG. 10 is a scanning electron microscope images in which the surfaces of the Bi2212 test pieces were baked and gradually cooled, where FIGS. 10A to 10D show those for combination conditions (surrounding gas, , annealing rate) of (air, -4 °C/h), (air, -12 °C/h), (oxygen, -4 °C/h), and (oxygen, -12 °C/h). Structures on the surface that look like amorphous particle shapes such as acicular shapes are crystals and non-crystalline parts that are not formed properly, and we believe that the smaller the number of such structures, the better the desired crystal is formed. FIGS. 11 and 12 are charts of X-ray diffraction obtained by forming test pieces of Bi2212 in an oxygen at an annealing rate of -4 °C/h or -12 °C/h, respectively. In comparison with -12 °C/h shown in FIG. 12, at -4 °C/h in FIG. 11, the peaks of 008, 0010, and 0012 are higher than those at -12 °C/h and -4 °C/h, thus it was confirmed that the crystal of Bi2212 was formed more favorably at -4 °C/h when -4 °C/h and -12 °C/h are compared. Even in the air, it was confirmed that better crystals were formed at -4 °C/h when -4 °C/h and -12 °C/h are compared (not shown).

Next, in order to confirm the performance of the superconducting layer in these four pieces of test piece, the superconducting critical temperature and the superconducting critical current were measured. FIG. 13 is a graph in which magnetic susceptibility is measured by raising and lowering the temperature in order to measure the superconducting critical temperature in the test pieces of Bi2212. First, centering operation of the test piece placed in the measuring device (Quantum Design Co., MPMS-XL 7) at an absolute temperature of 50 K is performed. The measurement of the magnetic susceptibility was performed, while an external magnetic field of 100 Oe was continuously applied to the test piece in the thickness direction thereof, and the temperature operation of raising and lowering in steps in each temperature section is carried out, like temperature operation as in the order in Table 6. With respect to the intensity of the magnetic field with Oe as a unit, 10,000 Oe corresponds to 795.8 kA/m, and it is converted into the strength of the magnetic field which generates the magnetic flux density of 1 T in the vacuum.

[Table 6]

| Order | Temperature Range (Start → End) | Step (+:Increase, -:Decrease) |
|---|---|---|
| 1 | 50 K → 80 K | +2 K |
| 2 | 80 K → 100 K | +1 K |
| 3 | 100 K → 120 K | +2 K |
| 4 | 120 K → 100 K | -2 K |
| 5 | 100 K → 80 K | -1 K |
| 6 | 80 K → 50 K | -2 K |

The result is as shown in FIG. From the curve of FIG. 13, the critical temperature (K) for each test piece was obtained as shown in Table 7.

[Table 7]

| Test Piece (Atmosphere, Cooling Rate) | | Critical Temperature (K) |
|---|---|---|
| Air | -4°C/Hour | 84 |
| Air | - 1 2 °C/Hour | 80 |
| Oxygen | - 4 °C/Hour | 82 |
| Oxygen | - 1 2 °C/Hour | 77 |

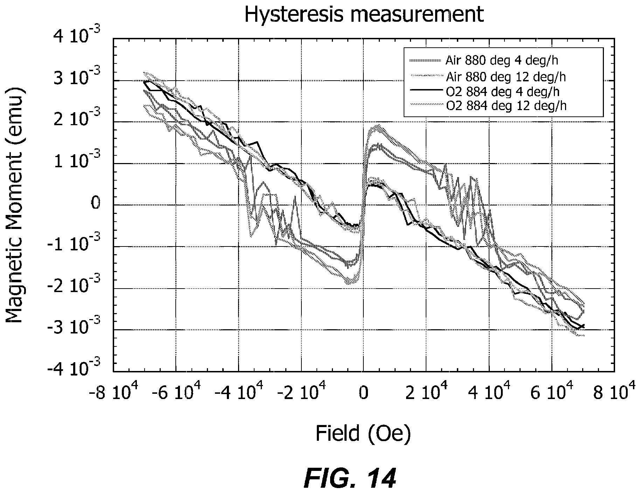

In addition, FIG. 14 is a graph obtained by measuring the hysteresis characteristic of magnetic susceptibility in order to measure the superconducting critical current in the test pieces of Bi2212. In this measurement, as the first operation of releasing the magnetic flux that was magnetized, the temperature was raised to 300 K once with the magnetic field being 0 Oe. Subsequently, for all the test pieces, the temperature was lowered to 77 K at which the superconducting transition takes place, for measuring the temperature. The magnetic field applying condition for measuring the hysteresis characteristic is as follows. First, the initial magnetization is canceled by sweeping the magnetic field from 0 Oe to 70300 Oe, and then the magnetic field operation for measurement was carried out. The magnetic susceptibility was measured with the value of each magnetic field, while the magnetic field was manipulated with steps of field intensity in each field sections as in Table 8.

[Table 8]

| Order | Magnetic Field (Oe) (Start → End) ) | Step (Oe) (+:Increase, -:Decrease) |
|---|---|---|
| 1 | 70,000 → 6,000 | - 2,000 |
| 2 | 6,000 → 1,000 | -200 |
| 3 | 1,000 → -1,000 | -100 |
| 4 | -1,000 → -6,000 | - 200 |
| 5 | -6,000 → -70,000 | -2,000 |
| 6 | -70,000 → -6,000 | +2,000 |
| 7 | -6,000 → -1,000 | +200 |
| 8 | -1,000 → 1,000 | +100 |
| 9 | 1,000 → 6,000 | +200 |
| 10 | 6,000 → 70,000 | +2,000 |

The result is as shown in FIG. From the curves in of FIG. 14, the critical current value J (A / cm) for each test piece was obtained as shown in Table 9.

[Table 9]

| Test Piece (atmosphere cooling rate ) | | Magnetic Moment (emu) | $J_C$ (A/cm$^2$) |
|---|---|---|---|
| Air | - 4 °C/Hour | 2.00E-03 | 361.10 |
| Air | - 1 2 °C/Hour | 8.00E-04 | 161.67 |
| Oxygen | - 4°C/Hour | 8.00E-04 | 108.91 |
| Oxygen | - 1 2 °C/Hour | 3.00E-03 | 331.61 |

The critical current values J in Table 9 areis given by the following Formula (21). [Math 21]

$$J_c = \frac{6}{w^2(3l - w)t}\Delta m \qquad (21)$$

where the superconductor part of the sample hasis a flat plate shape with a length l, a width w, and a thickness t;, $\Delta$ m is the magnetized hysteresis width of the magnetized hysteresis (magnetic moment) measured with the SQUID of the measurement ing device (MPMS-XL 7) Moment), that is, twice the measured magnetic moment. In Table 9, those with the same magnetic moment gives different values of the critical current value $J_c$ , because these values are those that were obtained through Formula (21) for derivation based on the actual size of the superconductor in the actual test pieces according to Formula (21).

From these results, it is reasonable to select Bi2212 that has been made e prepared under the conditions for providing with the highest transition temperature (84 K) and the maximum critical current density (361.10 A/cm $^2$), that is, the air was set used as the surrounding gas at an annealing rate of - 4 °C/h. It is reasonable to select Bi 2212 that has been made.

3-2. Operation verification

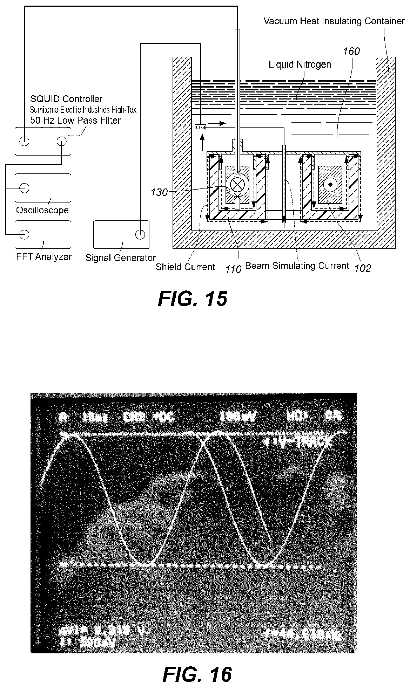

Next, the operation verification was carried out with the configuration having in which the induction ring 110 where in which the superconductor was actually formed was used and combined with the shield ring 160 adopting permalloy of high magnetic permeability, which is combined with the induction ring 110. FIG. 15 is an explanatory diagram showing setup for this operation verification. Note that the superconductor formed on the induction ring 110 is Bi 2212 formed on the silver substrate, which is formed under firing baking conditions in the air while the although the conditions of annealing slow cooling are different from those described in 3-1 is there. Although the superconducting transition temperature indicated by the superconductor formed on the induction ring 110 itself and which has been subjected to this operation verification cannot be measured, in the separately prepared sample which was prepared separately and melted under the same conditions, superconducting transition occurs at about 90 to 92 K. Also, in order to confirm the transition into superconductivity it was confirmed that the Meissner effect had actually occurred at the liquid nitrogen temperature (77 K) before the measurement operation by placing a the magnet near the induction ring 110 for the which performed the operation verification before the measurement operation, and the transition to superconductivity was confirmed Measurement was carried out prior to the measurement. The measurement for the operation verification was not for the beam current to be originally measured, but the simulated current passed through the shield ring 160 at to the position of the beam current was the target was the target. This simulated current is an AC sine waveform current of with a frequency of 20 Hz generated by a signal generator.

For calculation output, the magnetic flux density B generated on the SQUID sensor 130 by the simulated current I is expressed by the following expressed by the following Formula (22), where $\varphi$ is the magnetic flux on the sensor, S is the cross-sectional area of the magnetic core, G is the air gap, and N is the number of turns And is expressed by the following Formula (22).
[Math 22]

$$B = \frac{\varphi}{S} = \frac{\mu_0 N I}{G} \qquad (22)$$

From Formula (22), under the condition that the number of turns N = 1, the gap length G = 17 $\times$ 10 $^{-3}$ m, and

the simulated current I = 0.5 mA, the magnetic flux density B is calculated as 37.0 nT. Since the SQUID controller (Sumitomo Electric Industries High-Tex Co., Ltd. (currently: Sumitomo Electric System System Solutions Co., Ltd.), FIG. 15) which processes the signal of the SQUID sensor 130 has a magnetic field-voltage conversion coefficient of 14 nT/V, output from the controller is calculated to be 2.64 V under the above conditions.

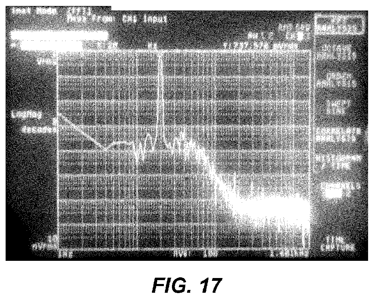

In the verification of the actual beam current measuring apparatus 100, the beam current measuring apparatus 100it was operated by a simulated current having an amplitude of 0.5 mA, in a peak-to-peak manner. FIG. 16 is a photograph of a display image on an analog oscilloscope for an output waveform from the controller is displayed, and FIG. 17 is a photograph of a display image of the FFT analyzer indicating an by FFT (Fast Fourier Transform) processing result of the its output waveform in frequency space. A controller output waveform with an amplitude of about 2.2 V was observed for a sinusoidal simulated current with an amplitude of 0.5 mA. Thus, it was confirmed that a good agreement could be found between the calculated value and the measured value. Further, in the display image of the FFT analyzer in FIG. 17, a component of 20 Hz was confirmed by a signal with a high SN ratio. The value of the noise level around the peak defining the noise floor in this display image is a value corresponding to a beam current of 50 nA. Therefore, it was confirmed that, by using the beam current measuring apparatus 100 of the present embodiment, the actual beam current can be measured up to as weak as about 50 nA, which can leads to have high sensitivity. Incidentally, as a numerical example to be compared with 50 nA, in the current measuring apparatus developed by the present inventor, the current resolution is about 500 nA for the conventional current measuring apparatus developed by the present inventor,, and the current resolution of a conventionally available non-contact DC ammeter is 10 μA is therethe current resolution is 10 μA for a commercially available non-contact DC ammeter.

The embodiments of the present invention have been concretely described above. Each of the above-described embodiments and examples has been described to explain the invention, and the scope of the invention of the present application should be determined based on the claims.

Industrial Applicability

The beam current measurement apparatus of the present invention can be used for any device that generates a charged particle beam.

Reference Signs List

100 beam current measurement apparatus
102, 102A, 102B, 202, 302 magnetic core
102C axis
102F funnel portion
104 magnetic gap
110, 310 guiding ring
110A inner cylindrical portion
110B outer cylindrical portion
110C bottom portion
112 core-side surface area
114 axis-side surface area
130 SQUID sensor
132 SQUID loop
134 antenna core
160, 360 shield ring
200 virtual core model
300 beam current measurement apparatus model
204, 304 magnetic gap
400 magnetic shield
410, 420 port
430 cooling port
510 magnetic field generating device
512A, 512B, 514A, 514B coil
520, 520A, 520B magnetic sensor
530 controller

**Claims**

1. A current measurement apparatus (100) for a charged particle beam, comprising:

   a magnetic core (102, 102A, 102B, 202) of a high permeability material encircling a space region ($V_c$) and substantially forming a ring around an axis (102C) passing through the space region ($V_c$), an induction ring (110, 310) disposed substantially coaxially with the magnetic core (102, 102A, 102B, 202), the induction ring (110, 310) forming a ring around the axis (102C) and occupying at least a part of the space region ($V_c$), wherein the induction ring (110, 310) is provided with a superconductor on, out of a surface or a surface layer thereof, a part or all of an axis-side surface region (114) being opposite to the axis (102C) and a core-side surface region (112) being opposite to the magnetic core (102, 102A, 102B, 202, 203, 902), the superconductor being configured to transmit therethrough a superconducting current along a path in a poloidal direction;
   a SQUID sensor (130) having a magnetic flux detection part magnetically coupled to a magnetic flux passing inside of the magnetic core (102, 102A, 102B, 202, 203, 902) in a toroidal direction; and
   a shield ring (160, 360) disposed substantially coaxially with the magnetic core (102, 102A, 102B, 202), and forming a ring around the axis (102C),

   wherein the induction ring (110, 310) and the shield ring (160, 360) form an annular housing space for accommodating the magnetic core (102, 102A, 102B, 202),
   **characterized in that**
   the shield ring (160, 360) and the induction ring (110, 310) are electrically insulated from each other.

2. The current measurement apparatus (100) according to claim 1, wherein the shield ring (160, 360) is a high permeability shield ring (160, 360) containing a high permeability material.

3. The current measurement apparatus (100) according to claim 1, wherein

   the shield ring (160, 360) has a superconductor formed on at least a part of a surface or a surface layer thereof, and the housing space is substantially surrounded by the superconductors of the induction ring (110, 310) and the shield ring (160, 360).

4. The current measurement according to claim 1, wherein the superconductor is Bi2212.

5. The current measurement apparatus (100) according to claim 1, wherein the magnetic core (102, 102A, 102B, 202) passes through the magnetic flux detection part of the SQUID sensor (130).

6. The current measurement apparatus (100) according to claim 1, wherein the magnetic core (102, 102A, 102B, 202) is provided with a magnetic gap (104, 204, 304) part at which the high permeability material is interrupted along a toroidal direction, and the SQUID sensor (130) is arranged so as to position the magnetic flux detection part in the magnetic gap (104, 204, 304) part.

7. The current measurement apparatus (100) according to claim 6, wherein the magnetic core (102, 102A, 102B, 202) is provided with a magnetic flux concentration part whose cross-sectional area is narrowed toward the magnetic gap (104, 204, 304) along the toroidal direction.

8. The current measurement apparatus (100) according to claim 6 or 7, further comprising an antenna core (134) of a high permeability material passing through the magnetic flux detection part of the SQUID sensor (130).

9. The current measurement apparatus (100) according to claim 1, wherein

   the current measuring apparatus (100) is located so that a charged particle beam to be detected passes through an inner space of the space region ($V_c$), the inner space being bounded by the induction ring (110, 310), each of the induction ring (110, 310) and the SQUID sensor (130) is maintained at a superconducting transition temperature thereof or lower, the induction ring (110, 310) is configured to allow the superconducting current induced in accordance with intensity of the charged particle beam to flow in a path in the superconductor along the poloidal direction, the path being from the axis-side surface region (114), through the core-side surface region (112), and returning to the axis-side surface region (114), and
the SQUID sensor (130) is configured to detect a magnetic flux along a toroidal direction by the magnetic flux detection part, the magnetic flux being formed inside the magnetic core (102, 102A, 102B, 202) by the superconducting current.

10. The current measurement apparatus (100) according to claim 3, wherein

the current measuring apparatus (100) is located so that a charged particle beam to be detected passes through an inner space of the space region ($V_c$), the inner space being bounded by the induction ring (110, 310) and the shield ring (160, 360),
each of the induction ring (110, 310), the shield ring (160, 360), and the SQUID sensor (130) is maintained at a superconducting transition temperature thereof or lower
the induction ring (110, 310) is configured to allow a superconducting current induced in accordance with intensity of the charged particle beam to flow in a path in the superconductor along the poloidal direction, the path being from the axis-side surface region (114), through the core-side surface region (112), and returning to the axis-side surface region (114),
the shield ring (160, 360) is configured to allow the superconducting current induced in accordance with the intensity of the charged particle beam to flow in a path along the poloidal direction of the superconducting material of the shield ring (160, 360), and
the SQUID sensor (130) is configured to detect a magnetic flux along a toroidal direction by the magnetic flux detection part, the magnetic flux being formed inside the magnetic core (102, 102A, 102B, 202) by the superconducting current.

11. The current measurement apparatus (100) for a charged particle beam according to claim 1, further comprising a magnetic shield configured to enclose at least one of the magnetic core (102, 102A, 102B, 202, 203, 902), the induction ring (110, 310), and the SQUID sensor (130) and to shield an ambient magnetic field.

12. The current measurement apparatus (100) for a charged particle beam according to claim 1, further comprising:

a magnetic field generating device (510) for applying a controlled magnetic field to at least one of the magnetic core (102, 102A, 102B, 202), the induction ring (110, 310), and the SQUID sensor (130).
an ambient magnetic sensor (520, 520A, 520B) for measuring at least one of intensity and a direction of an ambient magnetic field that may include a magnetic field generated by the magnetic field generating device (510), and
a control device for controlling the magnetic field generated by the magnetic field generating device (510) in response to at least one of the strength and the direction of the magnetic field detected by the ambient magnetic sensor (520, 520A, 520B).

**Patentansprüche**

1. Strommessvorrichtung (100) für einen Ladungsteilchenstrom, umfassend:

einen magnetischen Kern (102, 102A, 102B, 202) aus einem Material mit einer hohen Permeabilität, umgebend einen Raumbereich ($V_c$) und im Wesentlichen einen Ring um eine durch den Raumbereich ($V_c$) verlaufende Achse (102C) bildend,
einen Induktionsring (110, 310), angeordnet im Wesentlichen koaxial zum magnetischen Kern (102, 102A, 102B, 202), wobei der Induktionsring (110, 310) einen Ring um die Achse (102C) bildet und wenigstens einen Teil des Raumbereichs ($V_c$) einnimmt, wobei der Induktionsring (110, 310) mit einem Supraleiter auf, aus einer Oberfläche oder einer Oberflächenschicht hiervon, einem Teil oder der Gesamtheit eines achsseitigen Oberflächenbereichs (114) gegenüber der Achse (102C) und einem kernseitigen Oberflächenbereich (112) gegenüber dem magnetischen Kern (102, 102A, 102B, 202, 203, 902) ausgestattet ist, wobei der Supraleiter zum Leiten eines supraleitenden Stroms durch diesen hindurch entlang eines Weges in einer poloidalen Richtung ausgebildet ist;
einen SQUID-Sensor (130) mit einem Magnetfluss-Erfassungsteil, magnetisch gekoppelt mit einem im magnetischen Kern (102, 102A, 102B, 202, 203, 902) in einer toroidalen Richtung fließenden Magnetfluss; und
einen Schirmring (160, 360), angeordnet im Wesentlichen koaxial zum magnetischen Kern (102, 102A, 102B, 202) und einen Ring um die Achse (102C) bildend,

wobei der Induktionsring (110, 310) und der Schirmring (160, 360) einen ringförmigen Gehäuseraum zur Aufnahme des magnetischen Kerns (102, 102A, 102B, 202) bilden,
**dadurch gekennzeichnet, dass**
der Schildring (160, 360) und der Induktionsring (110, 310) voneinander elektrisch isoliert sind.

2. Strommessvorrichtung (100) nach Anspruch 1, wobei der Schildring (160, 360) ein Schildring (160, 360) mit einer hohen Permeabilität ist, enthaltend ein Material mit einer hohen Permeabilität.

3. Strommessvorrichtung (100) nach Anspruch 1, wobei

   der Schildring (160, 360) einen auf wenigstens einem Teil einer Oberfläche oder einer Oberflächenschicht hiervon ausgebildeten Supraleiter aufweist, und
   der Gehäuseraum im Wesentlichen von den Supraleitern des Induktionsrings (110, 310) und des Schirmrings (160, 360) umgeben ist.

4. Strommessvorrichtung nach Anspruch 1, wobei der Supraleiter Bi2212 ist.

5. Strommessvorrichtung (100) nach Anspruch 1, wobei der magnetische Kern (102, 102A, 102B, 202) durch den Magnetfluss-Erfassungsteil des SQUID-Sensors (130) verläuft.

6. Strommessvorrichtung (100) nach Anspruch 1, wobei der magnetische Kern (102, 102A, 102B, 202) mit einem Teil mit einem Luftspalt (104, 204, 304) ausgestattet ist, an dem das Material mit einer hohen Permeabilität entlang einer toroidalen Richtung unterbrochen ist, und
der SQUID-Sensor (130) so angeordnet ist, dass der Magnetfluss-Erfassungsteil im Teil mit einem Luftspalt (104, 204, 304) angeordnet ist.

7. Strommessvorrichtung (100) nach Anspruch 6, wobei der magnetische Kern (102, 102A, 102B, 202) mit einem Magnetfluss-Konzentrationsteil ausgestattet ist, dessen Querschnittsfläche zum Luftspalt (104, 204, 304) hin entlang der toroidalen Richtung schmäler wird.

8. Strommessvorrichtung (100) nach Anspruch 6 oder 7, ferner umfassend einen Antennenkern (134) aus einem Material mit einer hohen Permeabilität, das durch den Magnetfluss-Erfassungsteil des SQUID-Sensors (130) verläuft.

9. Strommessvorrichtung (100) nach Anspruch 1, wobei

   die Strommessvorrichtung (100) so angeordnet ist, dass ein zu erfassender Ladungsteilchenstrom durch einen Innenraum des Raumbereichs ($V_c$) strömt, wobei der Innenraum durch den Induktionsring (110, 310) begrenzt ist, sowohl der Induktionsring (110, 310) als auch der SQUID-Sensor (130) auf einer supraleitenden Übergangstemperatur hiervon oder niedriger gehalten wird,
   der Induktionsring (110, 310) zum Ermöglichen des Fließens des entsprechend der Intensität des Ladungsteilchenstroms induzierten supraleitenden Stroms in einem Weg im Supraleiter entlang der poloidalen Richtung ausgebildet ist, wobei der Weg vom achsseitigen Oberflächenbereich (114), durch den kernseitigen Oberflächenbereich (112) und zum achsseitigen Oberflächenbereich (114) zurück verläuft, und
   der SQUID-Sensor (130) zum Erfassen eines Magnetflusses entlang einer torodialen Richtung durch den Magnetfluss-Erfassungsteil ausgebildet ist, wobei der Magnetfluss im magnetischen Kern (102, 102A, 102B, 202) durch den supraleitenden Strom gebildet wird.

10. Strommessvorrichtung (100) nach Anspruch 3, wobei

    die Strommessvorrichtung (100) so angeordnet ist, dass ein zu erfassender Ladungsteilchenstrom durch einen Innenraum des Raumbereichs ($V_c$) strömt, wobei der Innenraum durch den Induktionsring (110, 310) und den Schirmring (160, 360) begrenzt ist,
    sowohl der Induktionsring (110, 310) als auch der Schirmring (160, 360) und der SQUID-Sensor (130) auf einer supraleitenden Übergangstemperatur hiervon oder niedriger gehalten wird,
    der Induktionsring (110, 310) zum Ermöglichen des Fließens eines entsprechend der Intensität des Ladungsteilchenstroms induzierten supraleitenden Stroms in einem Weg im Supraleiter entlang der poloidalen Richtung ausgebildet ist, wobei der Weg vom achsseitigen Oberflächenbereich (114), durch den kernseitigen Oberflächenbereich (112) und zum achsseitigen Oberflächenbereich (114) zurück verläuft,

der Schirmring (160, 360) zum Ermöglichen des Fließens des entsprechend der Intensität des Ladungsteilchenstroms induzierten supraleitenden Stroms in einem Weg entlang der poloidalen Richtung des supraleitenden Materials des Schirmrings (160, 360) ausgebildet ist, und

der SQUID-Sensor (130) zum Erfassen eines Magnetflusses entlang einer torodialen Richtung durch den Magnetfluss-Erfassungsteil ausgebildet ist, wobei der Magnetfluss im magnetischen Kern (102, 102A, 102B, 202) durch den supraleitenden Strom gebildet wird.

11. Strommessvorrichtung (100) für einen Ladungsteilchenstrom nach Anspruch 1, ferner umfassend einen zum Umschließen von wenigstens einem Element der Gruppe umfassend den magnetischen Kern (102, 102A, 102B, 202, 203, 902), den Induktionsring (110, 310) und den SQUID-Sensor (130) und zum Abschirmen eines Umgebungsmagnetfeldes ausgebildeten magnetischen Schirm.

12. Strommessvorrichtung (100) für einen Ladungsteilchenstrom nach Anspruch 1, ferner umfassend:

eine Magnetfeld-Erzeugungsvorrichtung (510) zum Anwenden eines gesteuerten Magnetfeldes auf wenigstens ein Element der Gruppe umfassend den magnetischen Kern (102, 102A, 102B, 202), den Induktionsring (110, 310) und den SQUID-Sensor (130), einen Umgebungsmagnetsensor (520, 520A, 520B) zum Messen der Intensität oder/und einer Richtung eines Umgebungsmagnetfeldes, das ein von der Magnetfeld-Erzeugungsvorrichtung (510) erzeugtes Magnetfeld umfassen kann, und

eine Steuervorrichtung zum Steuern des von der Magnetfeld-Erzeugungsvorrichtung (510) in Reaktion auf die Stärke oder/und die Richtung des vom Umgebungsmagnetsensor (520, 520A, 520B) erfassten Magnetfeldes erzeugten Magnetfeldes.

## Revendications

1. Appareil de mesure de courant (100) pour un faisceau de particules chargées, comprenant :

un noyau magnétique (102, 102A, 102B, 202) d'une matière à haute perméabilité encerclant un espace ($V_c$) et formant dans une large mesure une bague autour d'un axe (102C) traversant l'espace ($V_c$),

une bague d'induction (110, 310) disposée de manière coaxiale dans une large mesure avec le noyau magnétique (102, 102A, 102B, 202), la bague d'induction (110, 310) formant une bague autour de l'axe (102C) et occupant au moins une partie de l'espace ($V_c$), la bague d'induction (110, 310) étant munie d'un supraconducteur sur, à partir d'une surface ou d'une couche de surface de celle-ci, une partie ou la totalité d'une zone de la surface côté axe (114) opposée à l'axe (102C) et une zone de surface côté noyau (112) opposée au noyau magnétique (102, 102A, 102B, 202, 203, 902), le supraconducteur étant configuré pour transmettre à travers elle un courant supraconducteur cheminant dans une direction poloïdale;

un capteur SQUID (130) ayant un composant de détection de flux magnétique couplé magnétiquement à un flux magnétique passant à l'intérieur du noyau magnétique (102, 102A, 102B, 202, 203, 902) dans une direction toroïdale; et

une bague de blindage (160, 360) disposée de manière largement coaxiale avec le noyau magnétique (102, 102A, 102B, 202), et formant une bague autour de l'axe (102C),

la bague d'induction (110, 310) et la bague de blindage (160, 360) formant un espace de logement annulaire destiné à recevoir le noyau magnétique (102, 102A, 102B, 202), **caractérisé en ce que**

la bague de blindage (160, 360) et la bague d'induction (110, 310) sont isolées électriquement l'une de l'autre.

2. Appareil de mesure de courant (100) selon la revendication 1, la bague de blindage (160, 360) étant une bague de blindage à perméabilité élevée (160, 360) contenant une matière à perméabilité élevée.

3. Appareil de mesure de courant (100) selon la revendication 1,

la bague de blindage (160, 360) ayant un supraconducteur formé sur au moins une partie d'une surface ou d'une couche de surface de celle-ci et

l'espace de logement étant largement entouré par les supraconducteurs de la bague d'induction (110, 310) et de la bague de blindage (160, 360).

4. Appareil de mesure de courant selon la revendication 1, le supraconducteur étant du type Bi2212.

5. Appareil de mesure de courant (100) selon la revendication 1, le noyau magnétique (102, 102A, 102B, 202) passant à travers le composant de détection du flux magnétique du capteur SQUID (130).

6. Appareil de mesure de courant (100) selon la revendication 1, le noyau magnétique (102, 102A, 102B, 202) étant pourvu d'une pièce avec un entrefer magnétique (104, 204, 304) au niveau de laquelle la matière à haute perméabilité est interrompue le long d'une direction toroïdale, et
le capteur SQUID (130) étant disposé de manière à positionner le composant de détection du flux magnétique dans la partie avec un entrefer magnétique (104, 204, 304).

7. Appareil de mesure de courant (100) selon la revendication 6, le noyau magnétique (102, 102A, 102B, 202) étant pourvu d'un composant de concentration du flux magnétique dont la surface de la section transversale est rétrécie vers l'entrefer magnétique (104, 204, 304) le long de la direction toroïdale.

8. Appareil de mesure de courant (100) selon la revendication 6 ou 7, comprenant en outre un noyau d'antenne (134) d'une matière d'une perméabilité élevée passant à travers le composant de détection du flux magnétique du capteur SQUID (130).

9. Appareil de mesure de courant (100) selon la revendication 1,

l'appareil de mesure de courant (100) étant disposé de manière à ce qu'un faisceau de particules chargées à détecter traverse un espace intérieur de l'espace (V$_c$), l'espace intérieur étant délimité par la bague d'induction (110, 310),
tant la bague d'induction (110, 310) que le capteur SQUID (130) étant maintenus à une température de transition supraconductrice de ceux-ci ou inférieure,
la bague d'induction (110, 310) étant configurée pour permettre au courant supraconducteur induit en fonction de l'intensité du faisceau de particules chargées de circuler dans un chemin dans le supraconducteur le long de la direction poloïdale, le cheminement allant de la zone de surface côté axe (114), à travers la zone de surface côté noyau (112), et revenant à la zone de surface côté axe (114), et
le capteur SQUID (130) étant configuré pour détecter un flux magnétique le long d'une direction toroïdale par le composant de détection du flux magnétique, le flux magnétique étant formé à l'intérieur du noyau magnétique (102, 102A, 102B, 202) par le courant supraconducteur.

10. Appareil de mesure de courant (100) selon la revendication 3,

l'appareil de mesure de courant (100) étant disposé de manière à ce qu'un faisceau de particules chargées à détecter passe à travers un espace intérieur de l'espace (V$_c$), l'espace intérieur étant délimité par la bague d'induction (110, 310) et la bague de blindage (160, 360),
tant la bague d'induction (110, 310), que la bague de blindage (160, 360), et le capteur SQUID (130) étant maintenus à une température de transition supraconductrice de ceux-ci ou inférieure
la bague d'induction (110, 310) étant configurée pour permettre un courant supraconducteur induit selon l'intensité du faisceau de particules chargées de circuler dans un chemin dans le supraconducteur le long de la direction poloïdale, le cheminement allant de la zone de surface côté axe (114), à travers la zone de surface côté noyau (112), et retournant à la zone de surface côté axe (114),
la bague de blindage (160, 360) étant configurée de manière à permettre au courant supraconducteur induit selon l'intensité du faisceau de particules chargées de circuler dans un chemin le long de la direction poloïdale de la matière supraconductrice de la bague de blindage (160, 360), et
le capteur SQUID (130) étant configuré pour détecter un flux magnétique le long d'une direction toroïdale par le composant de détection du flux magnétique, le flux magnétique étant formé à l'intérieur du noyau magnétique (102, 102A, 102B, 202) par le courant supraconducteur.

11. Appareil de mesure de courant (100) pour un faisceau de particules chargées selon la revendication 1, comprenant en outre un écran magnétique configuré pour enfermer au moins l'un des noyaux magnétiques (102, 102A, 102B, 202, 203, 902), la bague d'induction (110, 310) et le capteur SQUID (130), et pour protéger d'un champ magnétique ambiant.

12. Appareil de mesure de courant (100) pour un faisceau de particules chargées selon la revendication 1, comprenant en outre:

un dispositif de génération de champ magnétique (510) destiné à appliquer un champ magnétique contrôlé à au moins l'un des éléments suivants: le noyau magnétique (102, 102A, 102B, 202), la bague d'induction (110, 310), et le capteur SQUID (130),

un capteur magnétique ambiant (520, 520A, 520B) pour mesurer au moins l'intensité et/ou une direction d'un champ magnétique ambiant qui peut inclure un champ magnétique généré par le dispositif de génération de champ magnétique (510), et

un dispositif de commande pour commander le champ magnétique généré par le dispositif de génération de champ magnétique (510) en réponse à la force et/ou la direction du champ magnétique détecté par le capteur magnétique ambiant (520, 520A, 520B).

**FIG. 1**

**FIG. 2**

**FIG. 3**

**FIG. 4A**

**FIG. 4B**

**FIG. 5**

**FIG. 6**

**FIG. 7**

FIG. 8

**FIG. 9A**

132   130

104   102

**FIG. 9B**

132   130

102A

**FIG. 9C**

132   130   134

104   102

**FIG. 9D**

132   130   134

104

102F   102F   102B

FIG. 10A

FIG. 10B

FIG. 10C

FIG. 10D

**FIG. 11**

**FIG. 12**

FIG. 13

EP 3 496 167 B1

FIG. 14

EP 3 496 167 B1

**FIG. 15**

**FIG. 16**

FIG. 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004356573 A
- JP 2014143243 A
- US 2006237660 A1
- JP 2003021670 A

### Non-patent literature cited in the description

- **TAMAKI WATANABE ; MASAYUKI KASE ; TAKESHI KATAYAMA.** SQUID to choudendoujikisi-rudo wo motiita koukando biimu denryuu monitaa no kaihatsu. *TEION KOGAKU,* 2003, vol. 38 (9), 509-521
- **WATANABE T. ; FUKUNISHI N. ; SASAKI Y. ; KASE M. ; GOTO A. ; KAMIGAITO O.** Development of Beam Current Monitor with High-Tc SQUID at RIBF. *Proceedings of BIW10,* 2010
- **M. KUCHNIR et al.** SQUID based beam current meter. *IEEE Trans. on Magnetics,* 1985, vol. 21 (2), 997-999
- Epitaxial Oxide Heterostructures for Ultimate High-Tc Quantum Interferometers. **MICHAEL I. FALEY.** Applications of High-Tc Superconductivity. InTech, 2011
- **SHUETSU HASEYAMA ; SHUJI YOSHIZAWA ; NORIFUMI MURAKAMI.** Supuree tohuhou ni yoru gin kibanjyou Bi2212 choudendou atsumaku rinkai denryuu (Jc) no koujyou. *J. Japan Inst. Metals,* 2002, vol. 66 (7), 723-727
- A cryogenic current-measuring device with nanoampere resolution at the storage ring TARN 11. **TANABE T et al.** Nuclear instruments and Methods in Physics Research. Elsevier, 21 May 1995, vol. 427, 455-464